(19) Europäisches Patentamt
European Patent Office
Office européen des brevets

(11) Veröffentlichungsnummer: **0 184 553 B1**

(12) # EUROPÄISCHE PATENTSCHRIFT

(45) Veröffentlichungstag der Patentschrift: **31.07.91**

(51) Int. Cl.5: **C08G 8/28**, C09D 5/44, G03F 7/16

(21) Anmeldenummer: **85810562.0**

(22) Anmeldetag: **25.11.85**

(54) **Modifizierte Phenolharze und deren Herstellung.**

(30) Priorität: **01.12.84 GB 8430377**

(43) Veröffentlichungstag der Anmeldung:
**11.06.86 Patentblatt 86/24**

(45) Bekanntmachung des Hinweises auf die Patenterteilung:
**31.07.91 Patentblatt 91/31**

(84) Benannte Vertragsstaaten:
**BE CH DE FR GB IT LI NL SE**

(56) Entgegenhaltungen:
**EP-A- 0 155 231**
**FR-A- 2 523 980**
**US-A- 4 362 853**
**FR-A- 1 517 197**
**US-A- 3 046 120**
**US-A- 4 410 675**

**PATENT ABSTRACTS OF JAPAN, Band 6, Nr. 255 (P-162)[1133], 14. Dezember 1982; & JP - A - 57 150 844 (KONISHIROKU SHASHIN K K K) 17-09-1982**

(73) Patentinhaber: **CIBA-GEIGY AG**
**Klybeckstrasse 141**
**CH-4002 Basel(CH)**

(72) Erfinder: **Demmer, Christopher George, Dr.**
**20 Wolsey Way**
**Cherry Hinton Cambridge CB1 3JQ(GB)**
Erfinder: **Irving, Edward, Dr.**
**41, Swaffham Road**
**Burwell Cambridge CB5 0AN(GB)**

**EP 0 184 553 B1**

Anmerkung: Innerhalb von neun Monaten nach der Bekanntmachung des Hinweises auf die Erteilung des europäischen Patents kann jedermann beim Europäischen Patentamt gegen das erteilte europäische Patent Einspruch einlegen. Der Einspruch ist schriftlich einzureichen und zu begründen. Er gilt erst als eingelegt, wenn die Einspruchsgebühr entrichtet worden ist (Art. 99(1) Europäisches Patentübereinkommen).

## Beschreibung

Die vorliegende Erfindung betrifft neue modifizierte Phenolharze und Verfahren zu deren Herstellung. Diese neuen Produkte sind lichtempfindlich und galvanisch abscheidbar.

Lichtempfindliche Phenol-Novolak Harze sind an sich bekannt und werden vor allem bei der Herstellung lichtempfindlicher Druckplatten für die Lithographie eingesetzt.

Die Verbindungen werden in der Regel durch Kondensation eines Phenolharzes mit Chinondiazidsulfonylchlorid hergestellt. Dabei entsteht ein Produkt, das infolge der Anwesenheit der Chinodiazidgruppen lichtempfindlich ist, und das infolge der Anwesenheit des Novolak-"Rückgrats" eine gute Haftfähigkeit und Zähigkeit aufweist. Platten, die mit diesen Materialien beschichtet wurden, zeigen gute mechanische Abriebfestigkeit beim lithographischen Druckverfahren. In der GB-PS 1,227,602 wird beispielsweise eine vorsensibilisierte lithographische Druckplatte beschrieben, die mit einem wasserunlöslichen Kondensationsprodukt beschichtet ist. Dieses Kondensationsprodukt ist der Ester einer Benzo- oder Naphthochinondiazidsulfonsäure mit einem Harz enthaltend phenolische Hydroxylgruppen. Ein Kresol-Formaldehydharz wird beispielhaft erwähnt.

In der GB-PS 1,329,888 wird das Kondensationsprodukt eines para-substituierten Phenolharzes, wobei eine Alkyl, Aryl-, Alkoxy-, Sulfoalkyl-, Aryloxy-, Aralkyloxy, Carboalkoxy-, Aralkyl- oder Acetylgruppe in p-Stellung zur phenolischen Hydroxygruppe steht, mit dem Sulfonylchlorid eines o-Benzochinon- oder o-Naphthochinondiazids beschrieben. Nach der Beschreibung sind diese Kondensationsprodukte besonders zur Herstellung von vorsensibilisierten Druckplatten für photomechanische Prozesse geeignet.

Die GB-PS 1,330,932 beschreibt Kondensationsprodukte von Benzochinon- oder Naphthochinondiazidsulfonylchloriden mit Novolaken, die sich von einem Bisphenol und Formaldehyd ableiten. Die Produkte können bei der Herstellung von lichtempfindlichen Platten für lithographische Verfahren eingesetzt werden.

Schliesslich beschreibt die US-PS 4,306,010 Kondensationsprodukte von o-Benzo- oder o-Naphthochinondiazidsulfonylchloriden mit einem Harz, das sich von einem mehrwertigen Phenol ableitet, beispielsweise von einem Resorcin-Benzaldehyd-Harz oder von einem Resorcin-4-methylbenzaldehyd-Harz. Diese Produkte eignen sich zur Herstellung von lichtempfindlichen Platten für die Lithographie.

Die galvanische Abscheidung von positiv-arbeitenden Photolacken führt zu sehr gleichmässigen Beschichtungen; dies ist besonders bei der Beschichtung von Kanten oder plattierten durchgehenden Oeffnungen wichtig, wenn relativ dünne Filme des Photolackes verwendet werden.

Der Einsatz dünner einheitlicher Filme führt potentiell zu höherer Auflösung verglichen mit konventionellen Filmen und flüssigen Photolacken. Ein weiterer Vorteil ist es, dass ein verringerter Bedarf an grossen "überstehenden Ringen" und an "Inseln" besteht, die zur Unterstützung des Photopolymerfilms über die plattierten durchgehenden Oeffnungen dienen; daher ist es möglich, eine grössere Fläche der Leiterplatte für Leiterlinien zur Verfügung zur stellen.

Darüber hinaus können galvanisch abscheidbare Photolacke mit einem geringen Anteil an organischen Lösungsmitteln formuliert werden und sie können aus Lösungen mit einem hohen Feststoffgehalt abgeschieden werden. Beide Eigenschaften sind aus Sicherheitsgründen und oekologischen Gründen erwünscht. Schliesslich ist der Verwendungsgrad des Photolackes hoch und es ist möglich, den Beschichtungsprozess vollständig zu automatisieren.

Es wurde nun gefunden, dass gewisse Novolake enthaltend Chinondiazidgruppen sich galvanisch abscheiden lassen, so dass Beschichtungen entstehen, die sich zur Herstellung gedruckter Schaltungen eignen, und die die oben erwähnten Vorteile aufweisen.

Die Fähigkeit der galvanischen Abscheidbarkeit dieser Harze basiert auf ihrem Vorliegen in Salzform. Die Herstellung dieser neuen Harze enthaltend eine lichtempfindliche Chinondiazidgruppe und eine salzbildende Gruppe, in der Regel eine Carbonsäuregruppe oder eine Aminogruppe, führt zu Verbindungen, die galvanisch abscheidbar sind unter Erhalt der Photosensibilität.

Carboxylgruppenhaltige, durch Chinondiazidgruppen modifizerte Novolakharze sind an sich bekannt. In diesen Verbindungen befinden sich die Carboxylgruppen allein in den Phenoleinheiten, die zur Herstellung des Novolaks verwendet wurden. Ein Beispiel für eine solche Einheit ist p-Hydroxybenzoesäure.

Es besteht allerdings ein Bedarf an Harzen mit einer besseren Stabilität in den Galvanisierbädern. Ausserdem werden Harze benötigt, die nach der bildmässigen Belichtung an den unbestrahlten Stellen eine verbesserte Resistenz gegenüber dem Entwickler aufweisen.

Es ist zwar bekannt, dass man die Stabilität von wässrigen Ueberzugszusammensetzungen aus phenolgruppenhaltigen Harzen verbessern kann, indem man diese Harze durch Reaktion mit einem Aldehyd und entweder mit einer Aminosäure, wie in der US-A 4,362,853 beschrieben, oder mit einer Mercaptocarbonsäure oder Schwefelsäure, wie aus der US-A 4,410,675 bekannt, oder mit einer Aminosulfonsäure oder Aminophosphonsäure, wie in der FR-A 2 523 980 beschrieben, modifiziert. Jedoch findet sich kein Hinweis

darauf, dass dadurch die Resistenz von phenol- und chinondiazidsulfonyloxygruppenhaltigen Harzen gegenüber Entwicklern an den unbestrahlten Stellen verbessert wird.

Die vorliegende Erfindung betrifft einen galvanisch abscheidbaren lichtempfindlichen phenolischen Novolak wobei

i) wenigstens ein Teil der phenolischen Hydroxylgruppen durch Chinondiazidsulfonyloxygruppen, vorzugsweise Benzo- oder Naphthochinondiazidsulfonyloxygruppen, ersetzt ist, und

ii) wenigstens ein Teil der aromatischen Ringe des Novolaks in ortho- und/oder para-Position zu einer phenolischen Hydroxylgruppe oder zur Chinondiazidsulfonyloxygruppe durch einen Rest der Formel $-CH(R^1)R^2$ substituiert ist, worin

$R^1$ Wasserstoff, Alkyl, Aryl oder eine Carbonsäuregruppe darstellt,

$R^2$ eine Sulfonsäuregruppe $-SO_3H$, ein Rest $-A-R^3-X$ oder eine Morpholinogruppe ist,

$R^3$ eine zweiwertige aliphatische, aromatische oder araliphatische Gruppe ist, die gegebenenfalls durch eine Carbonsäure-, Sulfonsäure- oder Phosphonsäuregruppe substituiert ist,

A ein Schwefelatom oder einen Rest der Formel $-N(R^4)-$ darstellt,

$R^4$ Wasserstoff oder Alkyl, das gegebenenfalls durch eine Carbonsäuregruppe, durch eine Hydroxylgruppe oder durch eine veretherte Hydroxylgruppe substituiert ist, bedeutet und

X eine Carbonsäure- oder Sulfonsäuregruppe darstellt, oder X, wenn A $-N(R^4)-$ bedeutet, darüber hinaus eine Phosphonsäuregruppe, eine Aminogruppe der Formel $-N(R^5)R^6$, ein Wasserstoffatom oder eine Hydroxylgruppe ist, und

$R^5$ und $R^6$ unabhängig voneinander ein Wasserstoffatom oder eine Alkyl-, Aryl-, Aralkyl- oder Alkenylgruppe, von denen jede gegebenenfalls durch eine Hydroxylgruppe substituiert ist, bedeuten.

Vorzugsweise leitet sich das Harz von einem einwertigen einkernigen Phenol ab, insbesondere von Phenol selbst und/oder von einem alkylsubstituierten Phenol. Es leitet sich aber auch von einem Bisphenol ab.

In der Regel sind wenigstens 4 % der phenolischen Hydroxylgruppen des Novolak-Harzes durch Chinondiazidsulfonyloxygruppen ersetzt, und das Harz enthält genügend freie phenolische Hydroxylgruppen, um in wässrigen Medien löslich oder dispergierbar zu sein.

Vorzugsweise sind 10 - 75 %, insbesondere 10 - 50 %, der phenolischen Hydroxylgruppen durch Chinondiazidsulfonyloxyreste ersetzt.

Einige der phenolischen Hydroxylgruppen können auch verethert sein. Sie liegen dann beispielsweise als Alkoxygruppen vor, in denen die Alkylgruppe wiederum eine Hydroxyl-, oder Alkoxygruppe tragen kann. Einige der phenolischen Hydroxylgruppen können aber auch eine Estergruppe tragen, die von der Chinondiazidsulfonyloxygruppe abweicht, beispielsweise Acetyloxy-, Benzoyloxy-, Methansulfonyloxy-, oder p-Toluolsulfonyloxygruppe.

In der Regel sind wenigstens 4 % der aromatischen Ringe des Novolak-Harzes durch eine Gruppe der Formel $-CH(R^1)R^2$ substituiert. Vorzugsweise beträgt der Anteil der auf diese Weise substituierten Ringe 7 - 75 %.

Bevorzugt werden Harze der allgemeinen Formel I

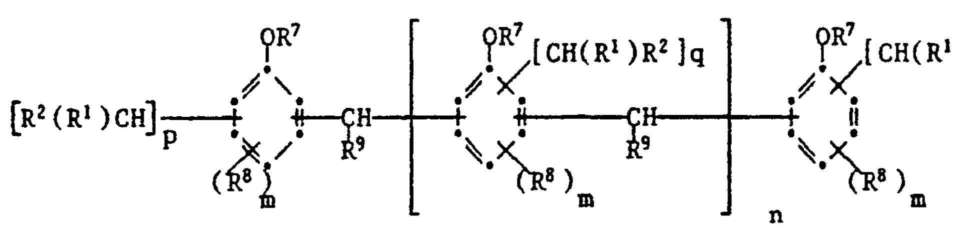

(I),

worin $R^1$ und $R^2$ die obengenannte Bedeutung besitzen,

$R^7$ Wasserstoff oder Alkyl bedeutet, wobei letzteres durch eine Hydroxyl- oder Alkoxygruppe substituiert sein kann, oder $R^7$ eine Gruppe der Formel $-SO_2R^{10}$, $-SO_2R^{11}$ oder $-COR^{12}$ ist, wobei wenigstens 4 % der Reste $R^7$ eine Gruppe $-SO_2R^{10}$ darstellen,

$R^8$ ein Halogenatom, eine Hydroxyl- oder Alkoxygruppe ist oder eine gegebenenfalls veresterte Carbonsäure- oder Sulfonsäuregruppe darstellt, oder eine Alkyl-, Alkenyl- oder Arylgruppe ist, die gegebenenfalls durch eine Hydroxylgruppe oder eine Carbonsäuregruppe substituiert ist, oder $R^8$ ein Rest der Formel $-N(R^{13})R^{14}$, $-COR^{12}$, $-OCOR^{12}$, $-OSO_2R^{10}$ oder $-OSO_2R^{12}$ ist, oder worin jeweils eine Gruppe $R^8$ pro aromatischem Rest eine Gruppe der

Formel II

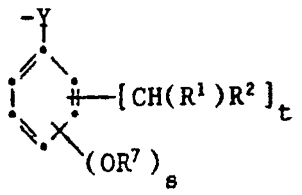

(II)

bedeuten kann, die gegebenenfalls an benachbarte aromatische Ringe über Gruppen der Formel -CH($R^9$)- geknüpft ist, worin

$R^9$ Wasserstoff oder Alkyl, Aryl oder eine Carbonsäuregruppe darstellt,

$R^{10}$ eine 1,2-Benzochinondiazid- oder 1,2-Naphthochinondiazidgruppe der Formel III oder IV bedeutet

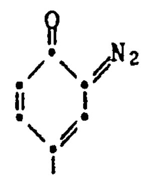

(III)

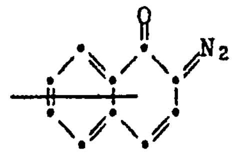

(IV),

wobei die freie Valenz der Naphthochinongruppe sich in 4- oder 5-Position befindet, worin

$R^{11}$ und $R^{12}$ unabhängig voneinander einen einwertigen aliphatischen, cycloaliphatischen, aromatischen oder araliphatischen Rest darstellen,

$R^{13}$ Wasserstoff, Alkyl oder ein Rest der Formel -$COR^{12}$, -$SO_2R^{10}$ oder -$SO_2R^{11}$ bedeutet,

$R^{14}$ Wasserstoff oder Alkyl ist,

Y ein Sauerstoff- oder Schwefelatom darstellt oder eine Carbonyl- oder eine Sulfonylgruppe ist oder eine $C_1$-$C_8$Alkylengruppe darstellt, die gegebenenfalls durch ein Halogenatom, eine Hydroxylgruppe, eine veretherte Hydroxylgruppe, eine Carbonsäuregruppe, eine veresterte Carbonsäuregruppe oder eine $C_6$-$C_{12}$Arylgruppe substituiert ist, wobei besagte Arylgruppe ebenfalls durch ein Halogenatom, eine Hydroxylgruppe, eine veretherte Hydroxylgruppe, eine Carbonsäuregruppe oder eine veresterte Carbonsäuregruppe substituiert sein kann,

m 0 oder 1, 2 oder 3 ist

n 0 oder eine ganze Zahl von 1 bis 20, bevorzugt 1 bis 10, bedeutet,

p, r und t unabhängig voneinander 0, 1 oder 2 sind,

q 0 oder 1 bedeutet,

s 1 oder 2 ist,

und die Summe ($p+nq+r+t$) so gewählt wird, dass wenigstens 4 % der betreffenden aromatischen Ringe in ortho- und/oder para-Position zur Gruppe -$OR^7$ durch eine Gruppe der Formel -CH($R^1$)$R^2$ substituiert sind, die Summe $m+p$ oder $m+r$ nicht grösser als 4 ist, und die Summe $m+q$ nicht grösser als 3 ist.

Vorzugsweise stellen 10 bis 75 %, insbesondere 10 bis 50 %, der Reste $R^7$ Gruppen der Formel -$SO_2R^{10}$ dar.

Damit das Harz in wässrigen Medien verdünnbar ist, sollten vorzugsweise wenigstens 25 %, insbesondere wenigstens 50 %, der Reste $R^7$ ein Wasserstoffatom darstellen. Berücksichtigt man diese Bevorzugung, so sollten einige der Reste $R^7$, vorzugsweise nicht mehr als 40 %, eine Gruppe der Formel -$SO_2R^{11}$ oder -$COR^{12}$ darstellen, oder sie sollten eine Alkylgruppe bedeuten, die gegebenenfalls durch eine Hydroxyl- oder Alkoxygruppe substituiert ist.

Die Summe $p+nq+r+t$ wird vorzugsweise so gewählt, dass 7 bis 75 % der besagten aromatischen Ringe durch eine Gruppe der Formel -CH($R^1$)$R^2$ substituiert sind.

Vorzugsweise haben die unter den Resten $R^1$, $R^4$, $R^5$, $R^6$, $R^7$, $R^8$, $R^{13}$ und $R^{14}$ bezeichneten Alkyl-, Alkoxy- oder Alkenylgruppen eine Kohlenstoffzahl von bis zu 20, vorzugsweise von bis zu 10.

Die Aryl- und Arylalkylgruppen innerhalb der Definitionen von $R^1$, $R^5$, $R^6$, $R^8$ und $R^9$ besitzen vorzugsweise eine Kohlenstoffanzahl von bis zu 20, insbesondere bis zu 15.

Die zweiwertigen Reste $R^3$ besitzen vorzugsweise bis zu 15, insbesondere bis zu 10, Kohlenstoffatome, wenn sie aliphatisch sind, und bis zu 20, insbesondere bis zu 15, Kohlenstoffatome, wenn sie aromatisch oder araliphatisch sind.

Einwertige Reste innerhalb der Definitionen $R^{11}$ und $R^{12}$ besitzen vorzugsweise bis zu 20, insbesondere bis zu 15, Kohlenstoffatome, wenn sie aliphatisch, aromatisch oder araliphatisch sind, und bis zu 15, insbesondere bis zu 10, Kohlenstoffatome, wenn sie cycloaliphatisch sind.

Vorzugsweise ist $R^1$ Wasserstoff, Methyl, Ethyl oder Phenyl sowie eine Carbonsäuregruppe.

Harze, worin $R^1$ Wasserstoff bedeutet, sind besonders bevorzugt.

$R^2$ ist vorzugsweise eine Sulfonsäuregruppe oder insbesondere ein Rest der Formel $-A-R^3-X$, worin $R^3$ $C_1$-$C_6$Alkylen bedeutet, das gegebenenfalls durch eine Carbonsäuregruppe substituiert ist, oder eine Phenylengruppe ist, A ein Schwefelatom oder ein Rest der Formel $-N(R^4)-$ ist, $R^4$ Wasserstoff oder $C_1$-$C_6$Alkyl ist, das durch eine Hydroxylgruppe substituiert sein kann, oder eine Carbonsäuregruppe darstellt, X eine Carbonsäure- oder Sulfonsäuregruppe ist, wenn A ein Schwefelatom darstellt, oder X ein Wasserstoffatom, eine Hydroxylgruppe, eine Carbonsäure-, Sulfonsäure- oder eine Aminogruppe der Formel $-N(R^5)R^6$ darstellt, wenn A eine Gruppe $-NR^4-$ ist, wobei $R^5$ und $R^6$ unabhängig voneinander Wasserstoff oder $C_1$-$C_6$Alkyl sind, oder $R^6$ stellt vorzugweise eine Morpholinogruppe dar.

Besonders bevorzugte Reste $R^2$ sind die Sulfonsäuregruppe sowie Reste der Formeln $-N(CH_3)-CH_2COOH$, $-N(CH_2COOH)CH_2COOH$, $-NH-o-C_6H_4COOH$, $-NHCH_2COOH$, $-NHCH(COOH)(CH_2)_2COOH$, $-NHCH(COOH)CH_2COOH$, $-NH-p-C_6H_4COOH$, $-SCH_2COOH$, $-SCH(CH_3)COOH$, $-SCH_2CH_2COOH$, $-SCH-(COOH)CH_2COOH$, $-NHCH_2CH_3$, $-N(CH_2CH_3)_2$, $-N[(CH_2)_5CH_3]_2$, $-NHCH_2CH_2OH$, $-NHCH_2CH_2OCH_3$, $-N-(CH_2CH_2OH)_2$, $-NH(CH_2)_3OH$, $-NH(CH_2)_4OH$, $-NHCH_2CH_2NH_2$ und $-N<(CH_2CH_2)_2>O$.

Stellt $R^7$ eine gegebenenfalls substituierte Alkylgruppe dar, ist es weiterhin bevorzugt, dass diese Alkylgruppe 1 bis 4 Kohlenstoffatome enthält, und dass sie gegebenenfalls durch eine Hydroxylgruppe oder durch eine $C_1$-$C_4$Alkoxygruppe substituiert ist. Zu den besonders bevorzugten Resten $R^7$ zählen beispielsweise Methyl, Ethyl, Isopropyl, n-Butyl, 2-Hydroxyethyl, 2-Hydroxypropyl, 2-Methoxyethyl und 2-Butoxyethyl.

Bevorzugte Atome und Reste $R^8$ sind Chlor und Brom sowie Hydroxygruppen, $C_1$-$C_4$Alkoxygruppen, $C_1$-$C_8$Alkylgruppen, Carbonsäurereste, Reste der Formeln $-OSO_2R^{10}$, $-OSO_2R^{11}$ und $-OCOR^{12}$ sowie Reste der Formel II, worin Y Methylen, Isopropyliden oder eine Carbonylgruppe oder eine Gruppe der Formeln $-CH(COOH)-$ oder $-C(CH_3)[(CH_2)_2COOH]-$bedeutet.

Besonders bevorzugt werden Harze, worin m 0 ist, so dass $R^8$ abwesend ist, oder worin m 1 bedeutet und die verschiedenen Gruppen $R^8$ gleiche oder unterschiedliche $C_1$-$C_8$-Alkylgruppen darstellen, oder worin in einigen der aromatischen Ringe der Formel I m 0 ist und für den Rest dieser Ringe m 1 bedeutet, wobei die verschiedenen Reste $R^8$ gleiche oder unterschiedliche $C_1$-$C_8$Alkylgruppen darstellen.

Besonders bevorzugte Alkylgruppen $R^8$ sind o-, m- und p-Methyl, o-, m- und p-tert.Butyl sowie o-, m- und p-Octyl.

$R^9$ ist vorzugsweise Wasserstoff, Methyl, Ethyl oder Phenyl sowie eine Carbonsäuregruppe.

Harze, worin $R^9$ Wasserstoff bedeutet, sind ganz besonders bevorzugt.

$R^{10}$ bedeutet bevorzugt eine 1,2-Naphthochinondiazidgruppe der Formel IV.

Bevorzugte Reste $R^{11}$ und $R^{12}$ sind $C_1$-$C_4$Alkyl und $C_6$-$C_{10}$Aryl, insbesondere Methyl, Phenyl und p-Tolyl.

$R^{13}$ ist vorzugsweise Wasserstoff, $C_1$-$C_4$Alkyl oder ein Rest der Formel $-SO_2R^{10}$, $-SO_2R^{11}$ oder $-COR^{12}$, worin $R^{10}$, $R^{11}$ und $R^{12}$ die weiter oben als bevorzugt definierte Bedeutung besitzen.

$R^{14}$ bedeutet vorzugsweise Wasserstoff oder $C_1$-$C_4$Alkyl.

Die Erfindung betrifft auch ein Verfahren zur Herstellung eines galvanisch abscheidbaren lichtempfindlichen Harzes der oben gegebenen Definition durch:

Umsetzen eines phenolischen Novolaks (A), der hergestellt wird aus einem Phenol (B) und einem Aldehyd (C), mit einer Chinondiazidsulfonsäure (D) oder einem ihrer reaktiven Derivate, wobei wenigstens eine der Komponenten, also der Novolak (A), das Phenol (B) und/oder das Reaktionsprodukt des Novolaks (A) mit dem Chinondiazid (D) weiter umgesetzt wird mit einem Aldehyd (E) und einer Komponente (F) ausgewählt aus der Gruppe bestehend aus primärem oder sekundärem Amin, einer Säure, die eine primäre oder sekundäre Aminogruppe oder eine Merkaptogruppe und eine Carbonsäuregruppe, eine Sulfonsäure- oder eine Phosphonsäuregruppe trägt, aus schwefeliger Säure oder aus einem wasserlöslichen Salz einer der besagten Säuren.

Vorzugsweise umfasst das Verfahren die Umsetzung des phenolischen Novolak-Harzes (A) mit der Chinondiazidsulfonsäure (D) oder einem ihrer reaktiven Derivate gefolgt von der Reaktion des Produktes mit dem Aldehyd (E) und mit dem Reaktanden (F); oder das Verfahren umfasst bevorzugt die Umsetzung des phenolischen Novolak-Harzes (A) mit dem Aldehyd (E) und dem Reaktanden (F), gefolgt von der Umsetzung des resultierenden Produktes mit einer Chinondiazidsulfonsäure (D) oder einem ihrer reaktiven

Derivate.

Falls gewünscht, können freie phenolische Reste durch ein Veretherungsmittel (G) verethert werden, oder sie können durch ein Veresterungsmittel (H) verestert werden, wobei das Veresterungsmittel (H) sich von (D) unterscheidet.

Diese Veretherung oder zusätzliche Veresterung kann durchgeführt werden, indem man wenigstes eine der Komponenten, also den galvanisch abscheidbaren Photolack, den Novolak (A), das Reaktionsprodukt von (A) mit der Chinondiazidsulfonsäure (D) oder einem ihrer Derivate, oder das Reaktionsprodukt der Umsetzung von (A), dem Aldehyd (E) und dem Reaktanden (F), mit dem Veretherungsmittel (G) oder dem Veresterungsmittel (H), das sich von (D) unterscheidet, umsetzt.

Das Phenol (B), aus dem der Novolak (A) hergestellt wird kann ein- oder mehrwertig sein und ein oder mehrere aromatische Ringe aufweisen.

Wird das Harz (A) aus lediglich einem Phenol (B) hergestellt, so sollte letzteres 2 freie Positionen in ortho- und/oder para-Stellung zur phenolischen Hydroxylgruppe aufweisen.

Wird das Harz (A) aus einer Mischung von Phenolen (B) hergestellt, so sollte wenigstens eines dieser Phenole 2 freie Positionen in ortho- und/oder para-Stellung zur phenolischen Hydroxylgruppe aufweisen.

Bevorzugt werden Phenole (B) mit der allgemeinen Formel V

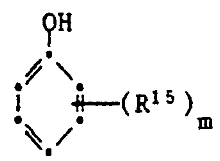 (V),

worin m 0, 1, 2 oder 3 ist, $R^{15}$ die gleiche Bedeutung wie $R^8$ in Formel I besitzt, mit der Massgabe, dass $R^{15}$ keine Gruppe der Formel II ist sondern an deren Stelle eine Gruppe der Formel VI auftritt

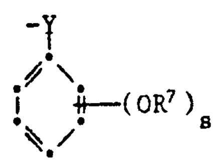 (VI),

worin Y, $R^7$ und s die oben definierten Bedeutungen besitzen.

Bevorzugte m-Werte entsprechen denen, die bereits weiter oben angegeben sind. Bevorzugte Atome oder Gruppen $R^{15}$ entsprechen denen, die weiter oben bereits für $R^8$ als bevorzugt angegeben wurden.

Geeignete Phenole (B) sind beispielsweise o-, m- und p-Chlorphenol, Resorcin, 2,2-Bis(4-hydroxyphenyl)propan, Bis(4-hydroxyphenyl)-methan, 4,4'Dihydroxybenzophenon, 2,2-Bis(4-hydroxyphenyl)essigsäure, 4,4-Bis(4-hydroxyphenyl)pentansäure, p-Hydroxybenzoesäure und Mischungen von zweien oder mehreren dieser Phenole.

Ganz besonders bevorzugt als Komponenten (B) werden Phenol, o-, m- oder p-Kresol, o-, m- oder p-tert.Butylphenol, o-, m- oder p-Octylphenol, sowie Mischungen zweier oder mehrerer dieser Phenole.

In besonders bevorzugten Ausführungsformen ist (B) eine Mischung von Phenol und p-tert.Butylphenol oder eine Mischung von m- und p-Kresolen.

Der Aldehyd (C), aus dem der Novolak (A) hergestellt wird, ist vorzugsweise eine Verbindung der Formel VII

$R^9$-CHO (VII),

worin $R^9$ und die bevorzugten Atome bzw. Gruppen $R^9$ die bereits oben angegebene Bedeutung besitzen.

Besonders bevorzugte Aldehyde sind Formaldehyd, Acetaldehyd, Propionaldehyd, Benzaldehyd und Glyoxylsäure, wovon Formaldehyd ganz besonders bevorzugt wird.

Die Reaktion zwischen Phenol (B) und Aldehyd (C) zum Novolak-Harz wird in der Regel nach an sich bekannten Verfahrensweisen durchgeführt, wobei das Phenol mit einem molaren Aequivalent, oder weniger, des Aldehyds in Gegenwart einer Säure erhitzt wird.

Das bevorzugte Chinondiazid-Derivat (D) entspricht der Formel VIII

$R^{10}-SO_2-Z$ (VIII),

worin $R^{10}$ und die bevorzugten Reste $R^{10}$ die oben angegebene Bedeutung besitzen und Z eine Hydroxylgruppe, eine Alkoxygruppe, bevorzugt mit 1 bis 4 Kohlenstoffatomen, oder ein Halogenatom, bevorzugt ein Chloratom, darstellt.

Vorzugsweise ist (D) 1,2-Naphthochinon-2-diazid-4- oder -5-sulfonylchlorid oder 1,2-Benzochinon-2-diazid-4-sulfonylchlorid.

Die Umsetzung zwischen (D) und dem phenolischen Novolak (A) oder dem Phenol (B) oder dem Reaktionsprodukt aus phenolischem Novolak (A), Aldehyd (E) und Reaktand (F) wird in der Regel in einem inerten Lösungsmittel durchgeführt.

Beispiele für diese Lösungsmittel sind Ketone oder Ether. Die Umsetzung wird in der Regel bei Raumtemperatur in Gegenwart eines geeigneten Kondensationsmittels durchgeführt. Als Kondensationsmittel eignen sich beispielsweise Säuren, wenn Z eine Hydroxylgruppe oder eine Alkoxygruppe bedeutet, oder es eignet sich eine Base wenn Z ein Halogenatom ist.

Setzt man pro phenolischer Hydroxylgruppe des Novolaks (A) oder des Phenols (B) eine äquivalente Menge Chinondiazid (D) ein oder einen leichten Ueberschuss davon, so erhält man in der Regel ein vollständig verestertes Produkt.

Um jedoch eine befriedigende Löslichkeit des Produktes zu gewährleisten, ist es bevorzugt, dass dieses einige freie phenolische Hydroxylgruppen aufweist, und daher wird vorzugsweise weniger als ein Aequivalent des Chinondiazidderivates (D) bei der Veresterungsreaktion eingesetzt. Vorzugsweise setzt man 0,1 bis 0,75, insbesondere 0,1 bis 0,5, molare Anteile des Chinondiazidderivates (D) pro Aequivalent phenolischer Hydroxylgruppe des Novolaks (A) oder des Phenols (B) ein.

Der Aldehyd (E) entspricht vorzugsweise der Formel IX

$R^1-CHO$ (IX),

worin $R^1$ und die bevorzugten Reste $R^1$ die weiter oben angegebene Bedeutung besitzen. Dieser Aldehyd kann dem Aldehyd (C), der zur Herstellung des Novolaks (A) verwendet wird, entsprechen oder er kann verschieden davon sein.

Vorzugsweise handelt es sich beim Aldehyd (E) um Formaldehyd, entweder als solcher eingesetzt oder in der Form des Paraformaldehyds.

Der Reaktand (F) besitzt vorzugsweise die Formel X oder XI

$M_2SO_3$ (X), $H-A-R^3-X$ (XI),

worin M Wasserstoff oder ein einwertiges Metallatom bedeutet, und $R^3$, A und X sowie deren bevorzugte Ausführungsformen die schon weiter oben definierten Bedeutungen besitzen, oder stellt Morpholin dar.

Der Reaktand (F) ist vorzugsweise ein Alkalimetallsulfit, ein primäres oder sekundäres Alkylamin, worin eine oder mehrere der Alkylgruppen durch Alkoxyreste substituiert sein können, ein Alkylendiamin, Morpholin, oder ein Hydroxylamin, eine Aminocarbonsäure, worin eine Amino- und eine Carboxylgruppe an einen aliphatischen, aromatischen oder araliphatischen Rest gebunden sind, oder eine Merkaptocarbonsäure, worin eine Merkaptogruppe und eine Carboxylgruppe an einen aliphatischen, aromatischen oder araliphatischen Rest gebunden sind.

Insbesondere bevorzugt als Reaktanden (F) sind Natriumsulfit, Ethylamin, 2-Methoxyethylamin, Diethylamin, Dihexylamin, Ethylendiamin, Ethanolamin, Diethanolamin, Propanolamin, Butanolamin, Morpholin, Sarkosin, Iminodiessigsäure, Anthranilsäure, Glycin, Glutaminsäure, Asparaginsäure, p-Aminobenzoesäure, Thioglykolsäure, 2- oder 3-Merkaptopropionsäure und Thioäpfelsäure.

Unter einem gegebenenfalls einzusetzenden Veretherungsreagenz (G) ist ein an sich bekanntes Veretherungsreagenz zu verstehen, beispielsweise ein Alkohol, wie beispielsweise Methanol, Ethanol, Isopropanol, n-Butanol, Ethylenglykol, 2-Methoxyethanol oder 2-Butoxyethanol, ein Alkylenoxid, wie beispielsweise Ethylen- oder Propylenoxid, ein Dialkylsulfat, wie beispielsweise Dimethylsulfat, oder ein Alkylhalogenid, wie beispielsweise Methyliodid.

Unter einem gegebenenfalls einzusetzenden Veresterungsreagenz (H) ist in der Regel eine Carbonsäure oder eine Sulfonsäure oder eines ihrer Derivate zu verstehen, beispielsweise Verbindungen der Formeln XII oder XIII

$R^{11}-SO_2-Z$ (XII) oder $R^{12}-CO-Z$ (XIII),

worin $R^{11}$, $R^{12}$ und Z, sowie deren bevorzugte Ausführungsformen, die schon weiter oben definierten Bedeutungen besitzen.

Besonders bevorzugte Veresterungsmittel sind Acetylchlorid, Benzoylchlorid, Methansulfonylchlorid und p-Toluolsulfonylchlorid.

Die Umsetzung zwischen Aldehyd (E), Reaktand (F) und Novolak (A) oder dem Reaktionsprodukt des Novolaks (A) mit dem Chinondiazid (D) wird in der Regel in einem inerten Lösungsmittel, wie beispielsweise einem Alkohol, einem Alkoxyalkohol, einem Keton oder einem Ether, bei Raumtemperatur oder bei erhöhter Temperatur, vorzugsweise bei 40 - 180 °C, in Gegenwart einer ausreichenden Menge einer Base vorgenommen. Die Basenmenge wird so gewählt, dass wenigstens ein Teil der freien Säure neutralisiert wird.

Die Menge an Reaktand (F) beträgt vorzugsweise 0,04-2,0, besonders bevorzugt 0,07-0,8, molare Anteile pro Aequivalent phenolischer Hydroxylgruppe des Novolaks (A) oder des Reaktionsproduktes des Novolaks (A) mit dem Chinondiazid (D).

In der Regel setzt man den Aldehyd (E) im Ueberschuss, bezogen auf (F), zu. Bevorzugt werden 1,1-4,0 Mole des Aldehyds (E) pro Mol des Reaktanden (F).

Soll gegebenenfalls eine Veresterung mit dem Veresterungsmittel (H) vorgenommen werden, so wird diese Reaktion im allgemeinen in einem inerten Lösungsmittel durchgeführt, beispielsweise in einem Keton oder einem Ether. Die Umsetzung erfolgt in der Regel bei Raumtemperatur und in Gegenwart eines geeigneten Kondensationsmittels, das eine starke Säure sein kann, wenn Z eine Hydroxylgruppe oder eine Alkoxygruppe darstellt, oder das eine Base sein kann, wenn Z ein Halogenatom bedeutet.

Die Menge des Veresterungsmittels (H) beträgt vorzugsweise nicht mehr als 0,4 Mol pro Aequivalent phenolischer Hydroxylgruppe in (A).

Soll gegebenenfalls eine Veretherung unter Verwendung des Veretherungsmittels (G) durchgeführt werden, so kann nach an sich bekannten Verfahrensweisen der Veretherung phenolischer Harze vorgegangen werden. Vorzugsweise setzt man nicht mehr als 0,4 Mole des Veretherungsmittels (G) pro Aequivalent der phenolischen Hydroxylgruppe des Novolaks (A) ein.

Wenn die phenolischen Hydroxylgruppen in einem Novolak-Harz teilweise mit einem oder mehreren Veresterungsmitteln umgesetzt werden, so ist das so zu verstehen, dass man ein modifiziertes Harz erhält, in dem noch Moleküle vorhanden sind, worin alle aromatischen Ringe freie Hydroxylgruppen aufweisen, in dem aber auch Moleküle auftreten, worin alle aromatischen Ringe veresterte Hydroxylgruppen besitzen, und in dem auch Moleküle auftreten, worin einige der aromatischen Ringe freie Hydroxylgruppen tragen, während die restlichen aromatischen Ringe veresterte Hydroxylgruppen aufweisen. Formeln wie beispielsweise Formel I, die solche Harze darstellen, sind also als statistische Repräsentationen anzusehen, bei denen $R^7$ in einigen Ringen Wasserstoff bedeutet, während diese Gruppe an anderen Ringen $-SO_2R^{10}$ ist, an noch anderen Ringen $-SO_2R^{11}$ darstellt und an wieder anderen Ringen $-COR^{12}$ sein kann.

Aehnliche Ueberlegungen treffen auf Formel I zu, wenn es sich bei diesen Harzen um Verbindungen handelt, die sich von einer Mischung unterschiedlicher Phenole ableiten, worin einige der Ringe durch einen Rest $-CH(R^1)R^2$ substituiert sind und andere Ringe wiederum nicht substituiert sind.

Werden die Harze der vorliegenden Erfindung als galvanisch abscheidbare Photolacke verwendet, so setzt man sie in der Form ihrer Salze ein, die in wässrigen, eingeschlossen wässrig-organischen, Medien löslich oder dispergierbar sind.

Werden diese Harze daher in diesen Medien hergestellt, so dass sie in Form ihrer Salze vorliegen, so können diese Medien enthaltend diese Salze direkt im galvanischen Abscheidungsprozess eingesetzt werden.

Falls die Harze in Form ihrer Salze oder Basen isoliert werden, so werden sie vor ihrem Einsatz im galvanischen Abscheidungsprozess in ihre Salze übergeführt; dies geschieht zweckmässigerweise durch Zugabe einer geeigneten Säure oder Base, je nachdem, ob die salzbildenden Gruppen in den Resten $R^1$ und $R^2$ oder gegebenenfalls weitere salzbildende Gruppen, die in den Harzen vorhanden sein können, basischer oder saurer Natur sind.

Zu den geeigneten salzbildenden Säuren zählen beispielsweise Mineralsäuren, wie Salzsäure oder Schwefelsäure, oder organische Säuren, wie Essig-, Propion-, Milch-, Malein- oder Glykolsäure.

Zu den geeigneten salzbildenden Basen zählen beispielsweise anorganische Basen, wie Natrium- oder Kaliumhydroxid bzw. -carbonat oder Ammoniak, oder organische Basen, wie z.B. Triethylamin, Triethanolamin, Benzyldimethylamin, Dimethylethanolamin und Dimethylaminomethylpropanol.

Werden die erfindungsgemässen Salze als Photoresists eingesetzt, so können diese auf Trägern abgeschieden werden, wobei sich lichtempfindliche Elemente bilden.

Zu den geeigneten Trägern zählen Metalle, wie beispielsweise Aluminium und Kupfer, entweder in Form von festen Metallfolien oder als metallbeschichtetes Laminat.

Die Harze der vorliegenden Erfindung können allein oder, falls gewünscht, auch in Mischung mit Verbindungen, die in wässrigen Medien löslich oder dispergierbar sind, und die die Qualität des abgeschiedenen Ueberzugs verbessern helfen, eingesetzt werden. Zu den typischen Verbindungen zählen beispielsweise Acryl-, Alkyl-, Polybutadien- oder Epoxidharze, die in wässrigen Medien verdünnbar sind.

Die galvanische Abscheidung der neuen Harze erfolgt nach an sich bekannten Methoden. Generell legt man Spannungen bis zu 200 V für Zeitdauern bis zu 5 Minuten an, aber die genauen Bedingungen für die einzelnen Harze, Substrate und gewünschten Schichtdicken können vom Fachmann anhand von Routineversuchen leicht ermittelt werden.

Nach der galvanischen Abscheidung werden die Ueberzüge getrocknet und können dann aktinischer Strahlung ausgesetzt werden, vorzugsweise einer Strahlung von Wellenlängen zwischen 200-600 nm. Ueblicherweise erfolgt die Belichtung durch ein bildtragendes Diapositiv.

Anschliessende Entwicklung mit einem geeigneten wässrigen oder nichtwässrigen Lösungsmittel hinterlässt ein positives Bild auf dem Substrat.

Die folgenden Beispiele dienen zur Illustration der Erfindung. Dabei sind alle Teile und Prozentangaben auf das Gewicht bezogen.

Folgende Novolake werden als Ausgangsmaterialien eingesetzt:

Novolak I: Hierbei handelt es sich um einen Novolak, der durch Umsetzung von 3 Molen Phenol, 1 Mol p-tert.Butylphenol und Formaldehyd, sowie anschliessender Umsetzung mit 1,2-Naphthochinon-2-diazid-5-sulfonylchlorid, hergestellt wird.

Das Produkt ist ein Harz der Formel I, worin $R^9$ Wasserstoff bedeutet, 88 % der Gruppen $R^7$ Wasserstoff darstellen und der Rest die 1,2-Naphthochinon-2-diazid-5-sulfonylgruppe repräsentiert, m für 75 % des Moleküls 0 bedeutet und für die restlichen 25 % 1 ist, und $R^8$ in diesem Falle tert.Butyl darstellt, n einen Durchschnittswert von 7,1 besitzt, und p, q und r jeweils 0 sind.

Novolak II: Hierbei handelt es sich um einen Novolak, der durch Umsetzung von m-Kresol, p-Kresol und Formaldehyd in Gegenwart von Oxalsäure als Katalysator hergestellt wird. Das molare Verhältnis der Reaktanden beträgt dabei m-Kresol:p-Kresol:Formaldehyd:Oxalsäure 0,5:0,5:0,75:0,006.

Der Novolak besitzt einen Erweichungspunkt von 136° C und die Struktur der Formel I, worin $R^9$ Wasserstoff ist, $R^7$ Wasserstoff ist, m 1 bedeutet, $R^8$ m-Methyl und p-Methyl (in äquimolarer Menge) darstellt, p, q und r Jeweils 0 sind und n eine Zahl mit dem Mittelwert 4,9 ist.

Novolak III: Dies ist ein Novolak, der durch Umsetzung von Phenol, p-tert.Butylphenol, Formaldehyd und Oxalsäure im molaren Verhältnis von 0,75:0,25:0,9:0,046 erhalten wird. Dieser Novolak besitzt einen Erweichungspunkt von 119° C und hat die Struktur der Formel I, worin $R^9$ Wasserstoff ist, $R^7$ Wasserstoff bedeutet, m in 75 % des Moleküls 0 ist und in den restlichen 25 % des Moleküls 1 bedeutet, wobei $R^8$ dann p-tert.Butyl darstellt, n eine Zahl mit dem Mittelwert 7,5 bedeutet, und p, q und r jeweils 0 sind.

Beispiel 1: 10 g des Novolaks I werden in 50 g 2-Butoxyethanol gelöst und auf 50° C erwärmt. Eine Lösung aus 0,45 g Sarkosin, 0,33 g Paraformaldehyd (91 % HCHO-Gehalt), 1 g 20 %-ige wässrige Natronlauge und 10 g 2-Butoxyethanol werden zu dieser Mischung hinzugefügt und die Lösung wird 2 Stunden bei 50° C belassen. Anschliessend wird auf Raumtemperatur abgekühlt und 1000 ml Wasser werden hinzugefügt. 10 ml N-Salzsäure werden hinzugegeben und ein brauner harzartiger Niederschlag fällt aus. Dieses Produkt wird zu einem Pulver vermahlen, mit Wasser gewaschen und in einem Vakuumofen bei 35° C getrocknet. Man erhält 9,5 g eines Produktes der Formel I, worin m für 75 % des Moleküls 0 bedeutet und für die restlichen 25 % 1 ist, $R^8$ dann p-tert.Butyl ist, $R^9$ Wasserstoff darstellt, $R^1$ Wasserstoff ist, 88 % der Reste $R^7$ Wasserstoff sind und die restlichen 12 % dieser Reste $R^7$ 1,2Naphthochinon-2-diazid-5-sulfonyl bedeuten, $R^2$ einen Rest der Formel $-N(CH_3)CH_2COOH$ darstellt, und die Summe (p + nq + r) einen mittleren Wert in der Grösse besitzt, dass 8 % der betreffenden aromatischen Ringe durch den Rest $-CH(R^1)R^2$ substituiert sind, und n eine ganze Zahl mit dem Mittelwert 7,1 bedeutet.

Das Infrarotspektrum dieses Harzes zeigt folgende Absorptionsmaxima (gemessen in einer KBr-Platte): 3350, 2940, 2860, 2150, 2100, 1600, 1500, 1470, 1450, 1430, 1360, 1250, 1190 und 1100 $cm^{-1}$.

4 g dieses Produktes werden langsam zu einer Mischung aus 4 g 2-Butoxyethanol und 20 %-iger wässriger Kalilauge gegeben, wobei eine klare rotbraune Lösung entsteht, die weiter mit Wasser verdünnt wird, bis sie 10 % des Produktes enthält. Dieses Produkt wird dann auf einem kupferkaschierten Laminat anodisch abgeschieden, wobei eine Kathode aus rostfreiem Stahl eingesetzt wird. Nach 20 Sekunden Galvanisierdauer bei 40 V bildet sich eine 29 Mikrometer dicke Beschichtung. Das Laminat wird dem Bad entnommen, mit Wasser abgespült und 5 Minuten lang bei 90° C getrocknet. Es wird dann 1 Minute lang durch eine bildtragende Maske belichtet. Als Lichtquelle verwendet man eine 5000 W Mitteldruck-Quecksilberlampe in einer Entfernung von 75 cm. Nach dem Eintauchen in 2 %-ige wässrige Natriumhydroxylösung entsteht ein klares positives Bild der Maske.

Das freigelegte Kupfer wird durch Wegätzen mittels einer 40 %-igen wässrigen $FeCl_3$-Lösung bei 30° C

entfernt. Danach wird die Platte mit Wasser gewaschen und getrocknet. Der restliche Ueberzug wird anschliessend ein zweites Mal ohne Maske belichtet (5000 W Lampe; 1 Minute) und durch Eintauchen in 2 %-ige wässrige Natriumhydroxidlösung entfernt.

Beispiel 2: Beispiel 1 wird wiederholt, indem man 10 g Novolak I, 0,89 g Sarkosin, 0,66 g Paraformaldehyd, 2 g 20 %-ige wässrige Natronlauge und 60 g 2-Butoxyethanol miteinander umsetzt. Das Produkt ist ein Harz der Formel I, worin m 0 oder 1 ist, wobei das Verhältnis der Reste mit m = 0 : m = 1 3:1 beträgt, $R^8$ tert.Butyl ist, $R^1$ und $R^9$ Wasserstoff bedeuten, 88 % der Reste $R^7$ Wasserstoff sind und die restlichen 12 % 1,2-Naphthochinon-2-diazid-5-sulfonyl darstellen, $R^2$ eine Gruppe $-N(CH_3)CH_2COOH$ ist, und die Summe (p + nq + r) einen solchen Wert annimmt, dass 15 % der aromatischen Ringe einen Rest $-CH(R^1)R^2$ als Substituenten tragen, und n eine ganze Zahl mit Mittelwert 7,1, bedeutet.

Dieses Harz hat ein ähnliches Infrarot Absorptionsspektrum wie das Produkt aus Beispiel 1, es kann auf einem Substrat galvanisch abgeschieden werden und ein positives Bild kann hergestellt werden, genauso wie in Beispiel 1 beschrieben.

Beispiel 3: 12 g des Novolaks II werden in 30 g Aceton und 30 g Dioxan gelöst und mit einer Lösung von 4 g 1,2-Naphthochinon-2-diazid-5-sulfonylchlorid in 10 g Aceton und 10 g Dioxan behandelt. Der pH der Lösung wird auf den Wert 8 eingestellt, indem man 10 %-ige wässrige Natriumcarbonatlösung zufügt, und anschliessend 90 Minuten bei Raumtemperatur rührt. Anschliessend wird diese Lösung in 100 ml 3N-Salzsäure gegossen, und der ausgefallene Niederschlag abfiltriert, mit Wasser gewaschen und im Vakuumofen bei 35 °C getrocknet.

10 g dieses Produktes werden in 50 g 2-Butoxyethanol gelöst und auf 50 °C erwärmt. Eine Lösung aus 0,45 g Sarkosin, 0,33 g Paraformaldehyd, 1,0 g 20 %-iger wässriger Natronlauge und 10 g 2-Butoxyethanol wird dazugefügt und die Mischung für 3 Stunden bei 50 °C gehalten. Die Mischung wird mit 500 ml Wasser verdünnt und das Produkt durch Zugabe von N-Salzsäure ausgefällt. Der Niederschlag wird mit Wasser gewaschen und im Vakuumofen bei 35 °C getrocknet. Man erhält 10 g eines Produktes der Formel I, worin $R^1$ m-Methyl und p-Methyl (in äquimolaren Mengen) bedeutet, m 1 ist, $R^1$ und $R^9$ Wasserstoff sind, 86 % der Reste $R^7$ Wasserstoff bedeuten und 14 % 1,2-Naphthochinon-2-diazid-5-sulfonyl sind, $R^2$ ein Rest $-N(CH_3)-CH_2COOH$ ist, die Summe (p + nq + r) einen solchen Mittelwert annimmt, dass 7,4 % der aromatischen Ringe durch den Rest $-CH(R^1)R^2$ substituiert sind, und n eine ganze Zahl mit dem Mittelwert 4,9 darstellt.

Das Infrarotspektrum dieses Produktes zeigt Maxima der Absorption bei (gemessen in KBr Platten): 3350, 2940, 2860, 2150, 2100, 1600, 1490, 1450, 1400, 1360, 1260, 1190 und 1100 $cm^{-1}$.

Dieses Produkt kann auf einem Substrat galvanisch niedergeschlagen werden und es lässt sich ein positives Bild herstellen, so wie in Beispiel 1 beschrieben.

Beispiel 4: 8 g des Novolaks III werden in 40 g Aceton gelöst und mit einer Lösung von 4 g 1,2-Naphthochinon-2-diazid-5-sulfonylchlorid in 20 g Aceton behandelt. Die Mischung wird mittels 5 %-iger wässriger Natriumcarbonatlösung auf einen pH-Wert von 8 eingestellt und 1 Stunde lang bei Raumtemperatur gerührt. Anschliessend wird sie in 100 ml 3N Salzsäure gegossen, der Niederschlag wird abfiltriert, mit Wasser gewaschen und im Vakuumofen bei 35 °C getrocknet. Man erhält 10 g eines Produktes.

Dieses wird in 50 g 2-Butoxyethanol gelöst, auf 50 °C erwärmt und zu einer Lösung aus 0,45 g Sarkosin, 0,33 g Paraformaldehyd, 1,0 g 20 %-iger wässriger Natronlauge und 25 g 2-Butoxyethanol gegeben. Diese Mischung wird dann 2 Stunden lang bei 50 °C gehalten. Anschliessend wird sie langsam zu 500 ml 1N Salzsäure gegeben und der gelbe Niederschlag wird abfiltriert, mit Wasser gewaschen und im Vakuumofen bei 35 °C getrocknet. Man erhält 10 g eines Produktes der Formel 1, worin $R^8$ p-tert.Butyl bedeutet, m für 75 % des Moleküls 0 ist und für die restlichen 25 % 1 bedeutet, $R^1$ und $R^9$ Wasserstoff darstellen, 78 % der Reste $R^7$ Wasserstoff bedeuten und 22 % dieser Reste 1,2-Naphthochinon-2-diazid-5-sulfonyl sind, $R^2$ eine Gruppe $-N(CH_3)CH_2COOH$ ist, und die Summe (p + nq + r) einen solchen Mittelwert besitzt, dass 9 % aller aromatischen Ringe mit einer Grupe $-CH(R^1)R^2$ substituiert sind und n eine ganze Zahl mit dem Mittelwert 7,5 ist.

Dieses Harz besitzt ein ähnliches IR-Spektrum wie das Produkt von Beispiel 1. Es kann ebenfalls wie das Produkt von Beispiel 1 auf einem Substrat galvanisch abgeschieden werden und es lässt sich auch ein positives Bild erhalten.

Beispiel 5: 50 g des Novolaks III werden in 150 g 2-Butoxyethanol gelöst und mit einer Lösung aus 2,25 g Sarkosin, 1,65 g Paraformaldehyd, 50 g 20 %-iger wässriger Natronlauge und 50 g 2-Butoxyethanol behandelt. Die Mischung wird 4 Stunden lang auf 80 °C erwärmt, auf Raumtemperatur abgekühlt, mit 2 Litern Wasser verdünnt und mit Salzsäure auf einen pH-Wert von 3 eingestellt. Es bildet sich ein weisser harzartiger Niederschlag. Dieser wird abfiltriert und getrocknet. Das getrocknete Produkt wird zu einem Pulver, vermahlen, mit Wasser gewaschen und im Vakuumofen bei 35 °C getrocknet. Man erhält so 46 g eines Novolaks der Formel I, worin m für 25 % des Moleküls 1 bedeutet und für die restlichen 75 % 0 ist,

$R^8$ p-tert.Butyl ist, $R^1$, $R^7$ und $R^9$ Wasserstoffatome darstellen, $R^2$ eine Gruppe $-N(CH_3)CH_2COOH$ bedeutet, und die Summe (p + nq + r) einen solchen Mittelwert besitzt, dass 6 % der aromatischen Ringe durch die Gruppe $-CH(R^1)R^2$ substituiert sind, und worin n eine ganze Zahl ist, deren Mittelwert 7,5 beträgt.

9 g dieses Novolaks werden in 40 g Aceton gelöst und eine Lösung aus 3 g 1,2-Naphthochinon-2-diazid-5-sulfonylchlorid in 20 g Aceton zugefügt. Die Lösung wird durch Zugabe von 16,6 g 10 %-iger wässriger Natriumcarbonatlösung auf einem pH-Wert von 8 eingestellt, eine Stunde lang bei Raumtemperatur gerührt und anschliessend tropfenweise in 500 ml 1N Salzsäure gegeben. Man erhält einen gelben harzartigen Niederschlag, der abfiltriert wird, mit Wasser gewaschen wird und im Vakuumofen bei 35°C getrocknet wird. Man erhält 10 g eines Produktes, das ähnlich ist, wie das in Beispiel 4 hergestellte.

Beispiel 6: Man wiederholt die Prozedur von Beispiel 2, indem man das Sarkosin durch 0,75 g Glycin ersetzt. 10 g eines Produktes fallen in Form eines braunen Feststoffes an. Dieses Produkt besitzt einen Säurewert von 0,8 Aequivalenten/kg und hat die Strukturformel I worin m 0 oder 1 ist, und das Verhältnis von m = 0 und m = 1 3:1 beträgt, worin $R^8$ p-tert.Butyl ist, $R^1$ und $R^9$ beide Wasserstoff bedeuten, 88 % der Reste $R^7$ Wasserstoff sind und die restlichen 12 % 1,2-Naphthochinon-2-diazid-5-sulfonyl darstellen, $R^2$ $-NHCH_2COOH$ ist, und die Summe (p + nq + r) einen solchen Mittelwert besitzt, dass 15 % der aromatischen Ringe durch eine Gruppe $-CH(R^1)R^2$ substituiert sind, und n eine ganze Zahl ist, deren Mittelwert 7,1 beträgt.

Beispiel 7: 12 g des Novolaks III werden in 50 g 2-Butoxyethanol gelöst und mit 2,1 g Diethanolamin, 2,4 g Formalin (HCHO-Gehalt 38,3 %) und 2,1 g 75 %-iger Milchsäure behandelt. Diese Mischung wird 3 Stunden lang auf 80°C aufgeheizt, auf Raumtemperatur abgekühlt, mit 1 Liter Wasser verdünnt und auf einen pH-Wert von 6 eingestellt. Es fällt ein Niederschlag aus, der abfiltriert wird und im Vakuumofen bei 35°C getrocknet wird. Man erhält 12 g eines Milchsäuresalzes eines Novolaks der Formel I, worin m 0 oder 1 ist, und das Verhältnis von m = 0 und m = 1 3:1 beträgt, $R^8$ p-tert.Butyl ist, $R^1$, $R^7$ und $R^9$ jeweils Wasserstoff darstellen, $R^2$ eine Gruppe $-N(CH_2CH_2OH)_2$ ist, und die Summe (p + nq + r) einen solchen Mittelwert annimmt, dass 20 % der aromatischen Ringe durch Gruppen der Formel $-CH(R^1)R^2$ substituiert sind, und n eine ganze Zahl darstellt, deren Mittelwert 7,5 beträgt.

12 g dieses Novolaksalzes werden in 40 g Aceton gelöst und eine Lösung von 3 g 1,2-Naphthochinon-2-diazid-5-sulfonylchlorid in 20 g Aceton wird hinzugefügt. Diese Mischung wird durch Zugabe von 5 %-iger wässriger Natriumcarbonatlösung auf eine pH-Wert von 8 eingestellt und 1 Stunde lang bei Raumtemperatur gerührt.

Sie wird anschliessend durch Zugabe von N/10 Salzsäure auf einen pH-Wert von 3 eingestellt, und es entsteht eine klare Lösung. Dazu gibt man 20 %-ige wässrige Natronlauge bis zum pH-Wert von 6 und es bildet sich ein Niederschlag. Dieser wird abfiltriert und bei 35°C im Vakuumofen getrocknet. Man erhält 10,6 g eines Produktes der Formel I, worin m 0 oder 1 ist, das Verhältnis von m = 0 und m = 1 3:1 beträgt, $R^8$ p-tert.Butyl bedeutet, $R^1$ und $R^9$ jeweils Wasserstoff darstellen, 89 % der Reste $R^7$ Wasserstoff bedeuten und die restlichen 11 % 1,2-Naphthochinon-2-diazid-5-sulfonyl bedeuten, worin $R^2$ eine Gruppe $-N(CH_2CH_2OH)_2$ ist und die Summe (p + nq + r) einen solchen Mittelwert besitzt, dass 20 % der aromatischen Ringe durch die Gruppe $-CH(R^1)R^2$ substituiert sind, und worin n eine ganze Zahl ist, deren Mittelwert 7,5 darstellt.

Das IR-Spektrum dieses Produktes (gemessen in einer KBr Platte) zeigt Absorptionsmaxima bei: 3300, 2940, 2860, 2150, 2100, 1590, 1500, 1470, 1450, 1430, 1360, 1250, 1190, und 1080 $cm^{-1}$.

4 g dieses Produktes werden in 4 g 2-Butoxyethanol gelöst und mit 32 g Wasser verdünnt. Das Harz wird auf einer kupferkaschierten Laminatkathode galvanisch abgeschieden, wobei eine Anode aus rostfreiem Stahl eingesetzt wird. In 20 Sekunden entsteht bei einer Spannung von 10 V ein 6 Mikrometer dicker Niederschlag.

Das beschichtete Laminat wird aus dem Bad entfernt, mit Wasser gespült und 5 Minuten lang bei 90°C getocknet. Es wird anschliessend durch eine bildtragende Maske 1 Minute lang bestrahlt. Dabei verwendet man eine 5000 W Mitteldruck-Quecksilberlampe in einer Entfernung von 75 cm.

Nach dem Eintauchen in 2 %-ige wässrige Natronlauge entsteht ein klares positives Bild der Photomaske.

Beispiel 8: 10 g des Novolaks I werden in 50 g 2-Butoxyethanol gelöst und auf 50°C erwärmt. Dazu gibt man eine Lösung aus 4,2 g Diethanolamin, 5,8 g Formalin (38,8 %-ig), 4,7 g Milchsäure (75 %-ig) und 10 g 2-Butoxyethanol. Diese Mischung wird anschliessend 1,5 Stunden lang bei 70°C gerührt, nachfolgend auf Raumtemperatur abgekühlt und mit 1000 ml Wasser verdünnt. Zugabe von 1N Natronlauge bis zum pH-Wert von 6 führt zum Ausfallen eines Niederschlags, der abfiltriert wird, gewaschen wird und im Vakuumofen bei 35°C getrocknet wird. Man erhält 10,8 g eines Produktes der Formel I, worin m 0 oder 1 ist, das Verhältnis m = 0 und m = 1 3:1 beträgt, $R^8$ p-tert.Butyl darstellt, $R^1$ und $R^9$ Wasserstoff bedeuten, 88 % der Reste $R^7$ Wasserstoff darstellen und die restlichen 12 % 1,2-Naphthochinon-2-diazid-5-sulfonyl sind, worin

$R^2$ eine Gruppe $-N(CH_2CH_2OH)_2$ ist, und die Summe (p + nq + r) einen solchen Mittelwert einnimmt, dass 60 % der aromatischen Ringe eine Gruppe $-CH(R^1)R^2$ tragen, und n eine ganze Zahl ist, deren Mittelwert 7,1 bedeutet.

Das IR-Spektrum dieses Harzes (gemessen in einer KBr Platte) zeigt Absorptionsmaxima bei: 3350, 2940, 2860, 2150, 2100, 1590, 1500, 1470, 1450, 1430, 1360, 1250, 1190 und 1080 $cm^{-1}$.

Dieses Harz kann, wie in Beispiel 7 beschrieben, auf einem Substrat galvanisch abgeschieden werden und es lässt sich ein positives Bild herstellen.

Beispiel 9: 36 g Novolak III werden in 36 g 2-Buoxyethanol gelöst und 13,8 g Thioglykolsäure sowie 14,9 g Paraformaldehyd werden zugefügt. Die Mischung wird 2 Stunden lang auf 140 °C erwärmt. Anschliessend legt man ein Vakuum an, erhitzt auf 180 °C und entfernt die flüchtigen Bestandteile. Der zurückbleibende Novolak ist ein flexibler Feststoff und besitzt die Strukturformel I, worin m für 25 % des Moleküls 1 ist und für die restlichen 75 % des Moleküls 0 bedeutet, $R^8$ p-tert.Butyl ist, $R^1$, $R^7$ und $R^9$ Wasserstoff sind, $R^2$ eine Gruppe $-SCH_2COOH$ ist, die Summe (p + nq + r) einen solchen Mittelwert annimmt, dass 50 % der aromatischen Ringe durch eine Gruppe $-CH(R^1)R^2$ substituiert sind und n eine ganze Zahl mit dem Mittelwert 7,5 bedeutet.

18 g dieses Novolaks werden in 40 g Aceton gelöst und eine Lösung von 6 g 1,2-Naphthochinon-2-diazid-5-sulfonylchlorid in 20 g Aceton wird hinzugefügt. Diese Lösung wird mittels 56 g 10 %-iger wässriger Natriumcarbonatlösung auf einen pH-Wert von 8 eingestellt. Es wird 1 Stunde lang bei Raumtemperatur gerührt und dann tropfenweise in 2N Salzsäure gegeben (2 Liter).

Man erhält einen gelben harzartigen Niederschlag, der abfiltriert wird, gewaschen wird und im Vakuumofen bei 35 °C getrocknet wird. Man erhält 18,8 g eines Produktes der Formel I, worin m für 25 % des Moleküls 1 bedeutet und für 75 % des Moleküls 0 ist, $R^8$ p-tert.Butyldarstellt, $R^1$ und $R^9$ Wasserstoff bedeuten, 82 % der Reste $R^7$ Wasserstoff sind und die restlichen 18 % 1,2-Naphthochinon-2-diazid-5-sulfonyl bedeuten, worin $R^2$ eine Gruppe $-SCH_2COOH$ ist, die Summe (p + nq + r) einen solchen Mittelwert annimmt, dass 50 % der aromatischen Ringe durch eine Gruppe $-CH(R^1)R^2$ substituiert sind, und n eine ganze Zahl mit dem Mittelwert von 7,5 bedeutet.

Dieses Produkt kann auf einem Substrat galvanisch niedergeschlagen werden und es lässt sich ein positives Bild herstellen, wie in Beispiel 1 beschrieben.

Beispiel 10: Man stellt einen Novolak her, indem man Phenol, p-tert.Butylphenol, 4,4-Bis(4-hydroxyphenyl)pentansäure und Formaldehyd (als 38 %-ige Formalinlösung) unter Verwendung von Oxalsäure als Katalysator im Molverhältnis von 0,75 : 0,25 : 0,1 : 0,99 : 0,016 erhitzt.

Flüchtige Stoffe werden durch Destillation entfernt und man erhält einen Novolak mit einem Erweichungspunkt von 119 °C.

18 g dieses Novolaks werden in 50 g Aceton gelöst und mit einer Lösung aus 6 g 1,2-Naphthochinon-2-diazid-5-sulfonchlorid in 20 g Aceton behandelt. Diese Mischung wird durch Zugabe von 10 %-iger wässriger Natriumcarbonatlösung auf einen pH-Wert von 8 eingestellt und 1 Stunde lang bei Raumtemperatur gerührt. Die Lösung wird anschliessend tropfenweise zu einer 0,2 N Salzsäurelösung (2,5 Liter) gegeben und das entstandene ausgefallene Produkt abfiltriert. Der Niederschlag wird mit Wasser gewaschen und im Vakuumofen bei 35 °C getrocknet. Man erhält 18 g eines Harzes.

13,8 g dieses Harzes werden in 40 g 2-Butoxyethanol gelöst und auf 50 °C erwärmt. Dazu gibt man eine Lösung aus 0,61 g Sarkosin, 0,46 g Paraformaldehyd (HCHO-Gehalt 91 %), 1 g 20 %-iger wässriger Natronlauge und 15 g 2-Butoxyethanol. Die Reaktionsmischung wird 2 Stunden lang auf 50 °C gehalten und das Produkt durch Ausfällen in einer 0,13 N Salzsäurelösung abgetrennt. Es wird abfiltriert, gewaschen und im Vakuumofen bei 35 °C getrocknet. Man erhält 13 g eines Produktes der Formel I, worin 72 % der Gruppen $R^8$ p-tert.Butyl sind und die restlichen 28 % Reste der Formel II darstellen, worin s = 1 ist, m für 68 % des Moleküls 0 ist und für 32 % des Moleküls 1 bedeutet, $R^1$ und $R^9$ Wasserstoff bedeutet, 9 % der Gesamtzahl der Reste $R^7$ in Formel I bzw. der Reste $R^7$ in Formel II 1,2-Naphthochinon-2-diazid-5-sulfonyl darstellen und die restlichen 91 % Wasserstoff bedeuten, $R^2$ eine Gruppe $-N(CH_3)CH_2COOH$ ist, Y eine Gruppe der Formel $-C(CH_3)[(CH_2)_2COOH]-$ darstellt, die Summe (p + nq + r + t) einen solchen Mittelwert annimmt, dass 7 % der aromatischen Ringe durch eine Gruppe $-CH(R^1)R^2$ substituiert sind, und n eine ganze Zahl darstellt, deren Mittelwert 3,8 beträgt.

Das Produkt kann, wie in Beispiel 1 beschrieben, galvanisch auf einem Substrat niedergeschlagen werden und es lässt sich ein positives Bild herstellen.

Beispiel 11: 20 g des Novolaks I werden in 50 g 2-Butoxyethanol gelöst und auf 70 °C erwärmt. Dazu gibt man eine Lösung aus 2,9 g Diethylamin, 6,2 g Formalin (HCHO-Gehalt: 38,8 %), 4,8 g 75 %-ige Milchsäure und 5 g 2-Butoxyethanol und rührt diese Mischung 1 Stunde lang bei 70 °C. Nach dem Abkühlen auf Raumtemperatur wird 1000 ml Wasser enthaltend 1,6 g Natriumhydroxid hinzugefügt. Der Niederschlag wird abfiltriert, gewaschen und im Vakuumofen bei 35 °C getrocknet. Man erhält 10,8 g eines

Produktes der Formel I, worin m 0 oder 1 bedeutet, das molare Verhältnis m = 0 zu m = 1 3:1 ist, $R^8$ p-tert.Butyl ist, $R^1$ und $R^9$ Wasserstoff bedeuten, 88 % der Reste $R^7$ Wasserstoff sind und die restlichen 12 % 1,2-Naphthochinon-2-diazid-5-sulfonyl darstellen, $R^2$ eine Gruppe $-N(CH_2CH_3)_2$ bedeutet, die Summe (p + nq + r) einen solchen Mittelwert besitzt, dass 30 % der aromatischen Ringe durch die Gruppe $-CH(R^1)R^2$ substituiert sind, und n eine ganze Zahl mit dem Mittelwert 7,1 darstellt.

Das IR-Spektrum dieses Harzes (gemessen an einer KBr Platte) zeigt Absorptionsmaxima bei: 3350, 2950, 2860, 2160, 2120, 1610, 1590, 1500, 1480, 1470, 1450, 1440, 1400, 1360, 1260, 1230, 1210, 1190, 1170, 1150, 1110 und 1080 $cm^{-1}$.

Das Produkt kann, wie in Beispiel 1 beschrieben, galvanisch auf einem Substrat niedergeschlagen werden und man kann damit ein positives Bild herstellen.

**Patentansprüche**

**1.** Galvanisch abscheidbarer lichtempfindlicher phenolischer Novolak, wobei

i) wenigstens ein Teil der phenolischen Hydroxylgruppen durch Chinondiazidsulfonyloxygruppen ersetzt ist, und

ii) wenigstens ein Teil der aromatischen Ringe des Novolaks in ortho- und/oder para-Position zu einer phenolischen Hydroxylgruppe oder zur Chinondiazidsulfonyloxygruppe durch einen Rest der Formel $-CH(R^1)R^2$ substituiert ist, worin

$R^1$ Wasserstoff, Alkyl, Aryl oder eine Carbonsäuregruppe darstellt,

$R^2$ eine Sulfonsäuregruppe $-SO_3H$, ein Rest $-A-R^3-X$ oder eine Morpholinogruppe ist,

$R^3$ eine zweiwertige aliphatische, aromatische oder araliphatische Gruppe ist, die gegebenenfalls durch eine Carbonsäure-, Sulfonsäure- oder Phosphonsäuregruppe substituiert ist,

A ein Schwefelatom oder einen Rest der Formel $-N(R^4)-$ darstellt,

$R^4$ Wasserstoff oder Alkyl, das gegebenenfalls durch eine Carbonsäuregruppe, durch eine Hydroxylgruppe oder durch eine veretherte Hydroxylgruppe substituiert ist, bedeutet, und

X eine Carbonsäure- oder Sulfonsäuregruppe darstellt, oder X, wenn A $-N(R^4)-$ bedeutet, darüber hinaus eine Phosphonsäuregruppe, eine Aminogruppe der Formel $-N(R^5)R^6$, ein Wasserstoffatom oder eine Hydroxylgruppe ist, und

$R^5$ und $R^6$ unabhängig voneinander ein Wasserstoffatom oder eine Alkyl-, Aryl-, Aralkyl- oder Alkenylgruppe, von denen jede gegebenenfalls durch eine Hydroxylgruppe substituiert ist, bedeuten.

**2.** Harz gemäss Anspruch 1, worin die Chinondiazidsulfonyloxygruppe eine Benzo- oder Naphthochinondiazidsulfonyloxygruppe bedeutet.

**3.** Galvanisch abscheidbares lichtempfindliches phenolisches Novolakharz gemäss Anspruch 1 der Formel I

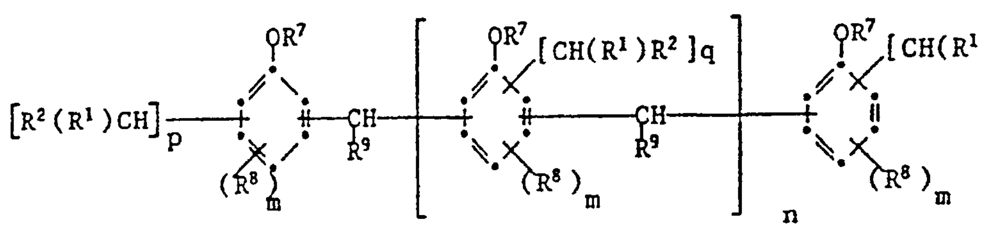

(I),

worin $R^1$ und $R^2$ die in Anspruch 1 genannte Bedeutung besitzen,

$R^7$ Wasserstoff oder Alkyl bedeutet, wobei letzteres durch eine Hydroxyl- oder Alkoxygruppe substituiert sein kann, oder $R^7$ eine Gruppe der Formel $-SO_2R^{10}$, $-SO_2R^{11}$ oder $-COR^{12}$ ist, wobei wenigstens 4 % der Reste $R^7$ eine Gruppe $-SO_2R^{10}$ darstellen,

$R^8$ ein Halogenatom, eine Hydroxyl- oder Alkoxygruppe ist oder eine gegebenenfalls veresterte Carbonsäure- oder Sulfonsäuregruppe darstellt, oder eine Alkyl-, Alkenyl- oder Arylgruppe ist, die gegebenenfalls durch eine Hydroxylgruppe oder eine Carbonsäuregruppe substituiert ist, oder ein Rest der Formel $-N(R^{13})R^{14}$, $-COR^{12}$,

$-OCOR^{12}$, $-OSO_2R^{10}$ oder $-OSO_2R^{12}$ ist, oder worin jeweils eine Gruppe $R^8$ pro aromatischem Rest eine Gruppe der Formel II

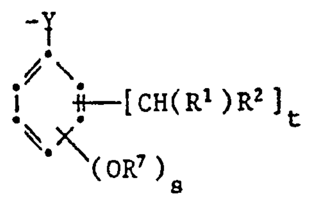

(II)

bedeuten kann, die gegebenenfalls an benachbarte aromatische Ringe über Gruppen der Formel $-CH(R^9)-$ geknüpft ist, worin

$R^9$ Wasserstoff oder Alkyl, Aryl oder eine Carbonsäuregruppe darstellt,

$R^{10}$ eine 1,2-Benzochinondiazid- oder 1,2-Naphthochinondiazidgruppe der Formel III oder IV bedeutet

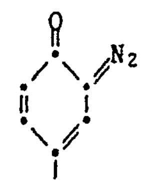

(III)

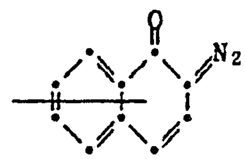

(IV),

wobei die freie Valenz der Naphthochinongruppe sich in 4- oder 5-Position befindet, worin

$R^{11}$ und $R^{12}$ unabhängig voneinander einen einwertigen aliphatischen, cycloaliphatischen, aromatischen oder araliphatischen Rest darstellen,

$R^{13}$ Wasserstoff, Alkyl oder ein Rest der Formel $-COR^{12}$, $-SO_2R^{10}$ oder $-SO_2R^{11}$ bedeutet,

$R^{14}$ Wasserstoff oder Alkyl ist,

Y ein Sauerstoff- oder Schwefelatom darstellt oder eine Carbonyl- oder eine Sulfonylgruppe ist oder eine $C_1$-$C_8$Alkylengruppe darstellt, die gegebenenfalls durch ein Halogenatom, eine Hydroxylgruppe, eine veretherte Hydroxylgruppe, eine Carbonsäuregruppe, eine veresterte Carbonsäuregruppe oder eine $C_6$-$C_{12}$Arylgruppe substituiert ist, wobei besagte Arylgruppe ebenfalls durch ein Halogenatom, eine Hydroxylgruppe, eine veretherte Hydroxylgruppe, eine Carbonsäuregruppe oder eine veresterte Carbonsäuregruppe substituiert sein kann,

m 0 oder 1, 2 oder 3 ist

n 0 oder eine ganze Zahl von 1 bis 20 bedeutet

p, r und t unabhängig voneinander 0, 1 oder 2 sind,

q 0 oder 1 bedeutet,

s 1 oder 2 ist,

und die Summe $(p+nq+r+t)$ so gewählt wird, dass wenigstens 4 % der betreffenden aromatischen Ringe in ortho- und/oder para-Position zur Gruppe $-OR^7$ durch eine Gruppe der Formel $-CH(R^1)R^2$ substituiert sind, die Summe $m+p$ oder $m+r$ nicht grösser als 4 ist, und die Summe $m+q$ nicht grösser als 3 ist.

**4.** Harz gemass Anspruch 3, worin 10 - 50 % der Reste $R^7$ eine Gruppe der Formel $-SO_2R^{10}$ darstellen, und worin 7 - 75 % der aromatischen Ringe durch eine Gruppe der Formel $-CH(R^1)R^2$) substituiert sind.

**5.** Harz gemass einem der Ansprüche 1-4, worin die Reste $R^1$, $R^4$, $R^5$, $R^6$, $R^7$, $R^8$, $R^{13}$ und $R^{14}$ als Alkyl, Alkoxy oder Alkenyl bis zu 20 Kohlenstoffatome aufweisen, die Reste $R^1$, $R^5$, $R^6$, $R^8$ und $R^9$ als Aryl oder Aralkyl bis zu 20 Kohlenstoffatome besitzen, die zweiwertigen Gruppen $R^3$, wenn sie aliphatisch sind, bis zu 15 Kohlenstoffatome, und wenn sie aromatisch oder araliphatisch sind, bis zu 20 Kohlenstoffatome aufweisen, und die einwertigen Reste $R^{11}$ und $R^{12}$, wenn sie aliphatisch, aromatisch

oder araliphatisch sind, bis zu 20 Kohlentoffatome, und wenn sie cycloaliphatisch sind, bis zu 15 Kohlenstoffatome aufweisen.

**6.** Harz gemäss einem der Ansprüche 1-5, worin $R^1$ Wasserstoff, Methyl, Ethyl oder Phenyl oder eine Carbonsäuregruppe bedeutet.

**7.** Harz gemäss einem der Ansprüche 1-6, worin $R^2$ eine Gruppe der Formel $-A-R^3-X$ darstellt, worin $R^3$ $C_1$-$C_6$Alkylen bedeutet, das gegebenenfalls durch eine Carbonsäuregruppe substituiert ist, oder eine Phenylengruppe ist, A ein Schwefelatom oder ein Rest der Formel $-N(R^4)-$ ist, $R^4$ Wasserstoff oder $C_1$-$C_6$Alkyl ist, das durch eine Hydroxylgruppe substituiert sein kann, oder eine Carbonsäuregruppe darstellt, X eine Carbonsäure- oder Sulfonsäuregruppe ist, wenn A ein Schwefelatom darstellt, oder X ein Wasserstoffatom, eine Hydroxylgruppe, eine Carbonsäure- oder Sulfonsäure-oder eine Aminogruppe der Formel $-N(R^5)R^6$ darstellt, wenn A eine Gruppe $-NR^4-$ ist, wobei $R^5$ und $R^6$ unabhängig voneinander Wasserstoff oder $C_1$-$C_6$Alkyl sind, oder $R^2$ eine Morpholinogruppe darstellt.

**8.** Harz gemäss einem der Ansprüche 3-7, worin m 0 ist, so dass $R^8$ abwesend ist, oder worin m 1 bedeutet und die verschiedenen Gruppen $R^8$ gleiche oder unterschiedliche $C_1$-$C_8$Alkylgruppen darstellen, oder worin in einigen der aromatischen Ringe der Formel I m 0 ist und für den Rest dieser Ringe m 1 bedeutet, wobei die verschiedenen Reste $R^8$ gleiche oder unterschiedliche $C_1$-$C_8$Alkylgruppen darstellen.

**9.** Harz gemäss einem der Ansprüche 1-8, dadurch gekennzeichnet, dass es sich um ein Salz handelt, das in einem wässrigen Medium löslich oder dispergierbar ist.

**10.** Verfahren zur Herstellung von galvanisch abscheidbaren lichtempfindlichen Harzen gemäss Anspruch 1 durch Umsetzen eines phenolischen Novolaks (A), der hergestellt wird aus einem Phenol (B) und einem Aldehyd (C), mit einer Chinondiazidsulfonsäure (D) oder einem ihrer reaktiven Derivate, wobei wenigstens eine der Komponenten, also der Novolak (A), das Phenol (B) und/oder das Reaktionsprodukt des Novolaks (A) mit dem Chinondiazid (D) weiter umgesetzt wird mit einem Aldehyd (E) und einer Komponente (F) ausgewählt aus der Gruppe bestehend aus primärem oder sekundärem Amin, einer Säure, die eine primäre oder sekundäre Aminogruppe oder eine Merkaptogruppe und eine Carbonsäuregruppe, eine Sulfonsäure- oder eine Phosphonsäuregruppe trägt, aus schwefeliger Säure oder aus einem wasserlöslichen Salz einer der besagten Säuren.

**11.** Verfahren gemäss Anspruch 10, umfassend die Umsetzung des phenolischen Novolakharzes (A) mit der Chinondiazidsulfonsäure (D) oder einem ihrer reaktiven Derivate gefolgt von der Reaktion des Produktes mit dem Aldehyd (E) und mit dem Reaktanden (F), oder umfassend die Umsetzung des phenolischen Novolakharzes (A) mit dem Aldehyd (E) und mit dem Reaktanden (F) gefolgt von der Umsetzung des resultierenden Produktes mit einer Chinondiazidsulfonsäure (D) oder einem ihrer reaktiven Derivate.

**12.** Verfahren gemäss Anspruch 10 oder 11, worin das Phenol (B) die allgemeine Formel V besitzt

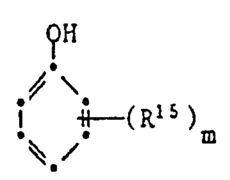

(V),

der Aldehyd (C) die Formel $R^9$-CHO besitzt, die Chinondiazidsulfonsäure (D) oder ihr reaktives Derivat die Formel $R^{10}-SO_2-Z$ aufweist, der Aldehyd (E) die Formel $R^1$-CHO besitzt und der Reaktand (F) die Formel $M_2SO_3$ oder $H-A-R^3-X$ besitzt,
worin $R^1$, $R^3$, A und X die in Anspruch 1 definierte Bedeutung aufweisen oder Morpholin ist $R^9$, $R^{10}$ und m die in Anspruch 3 definierte Bedeutung besitzen, $R^{15}$ die Bedeutung von $R^8$ besitzt, so wie sie in Anspruch 3 definiert wurde, mit der Massgabe, dass $R^{15}$ anstelle der Gruppe der Formel II eine Gruppe der Formel VI darstellt

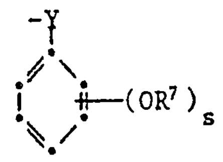

(VI),

worin Y, $R^7$ und s die in Anspruch 3 definierte Bedeutung besitzen, M Wasserstoff oder ein einwertiges Metallatom darstellt, und Z eine Hydroxyl- oder Alkoxygruppe oder ein Halogenatom ist.

**13.** Verfahren gemäss einem der Ansprüche 10-12, worin das Phenol (B) Phenol, o-, m- oder p-Kresol, o-, m- oder p-tert.Butylphenyl, o-, m-oder p-Octylphenol oder eine Mischung zweier oder mehrer dieser Verbindungen bedeutet.

**14.** Verfahren gemäss einem der Ansprüche 10-13, worin die Aldehyde (C) und (E) Formaldehyd bedeuten.

**15.** Verfahren gemäss einem der Ansprüche 10-14, worin (D) 1,2-Naphthochinondiazid-4- oder -5-sulfonylchlorid oder 1,2-Benzochinon-2-diazid-4-sulfonylchloridbedeutet.

**16.** Verfahren gemäss einem der Ansprüche 10-15, worin der Reaktand (F) ein Alkalimetallsulfit, ein primäres oder sekundäres Alkylamin, worin eine oder mehrere der Alkylgruppen durch Alkoxyreste substituiert sein können, ein Alkylendiamin, Morpholin, oder ein Hydroxylamin, eine Aminocarbonsäure, worin eine Amino- und eine Carboxylgruppe an einen aliphatischen, aromatischen oder araliphatischen Rest gebunden sind, oder eine Merkaptocarbonsäure, worin eine Merkaptogruppe und eine Carboxylgruppe an einen aliphatischen, aromatischen oder araliphatischen Rest gebunden sind, bedeutet.

**17.** Verfahren gemäss einem der Ansprüche 10-16, worin die Menge von (D) 0,1 bis 0,75 Mol pro Aequivalent phenolischer Hydroxylgruppe des Novolakharzes (A) beträgt, die Menge an Reaktand (F) 0,04 bis 2,0 Mol pro Aequivalent phenolischer Hydroxylgruppe des Novolakharzes (A) oder des Reaktionsproduktes von (A) mit (D) ist, und die Menge an Aldehyd (E) 1,1 bis 4,0 Mole pro Aequivalent an (F) beträgt.

**18.** Verfahren gemäss einem der Ansprüche 10-17, worin die Reaktion zwischen dem Aldehyd (E), dem Reaktanden (F) und dem Novolakharz (A) oder dem Reaktionsprodukt zwischen (A) und dem Chinodiazid (D) in einem inerten Lösungsmittel bei einer Temperatur von 40 bis 180°C durchgeführt wird, wobei genügend Base vorliegt, um zumindest einen Teil der freien Säure, zu neutralisieren.

## Claims

**1.** An electrodepositable, photosensitive, phenolic novolak where

(i) at least some of the phenolic hydroxyl groups are replaced by diazoquinonesulfonyloxy groups, and

(ii) at least some of the aromatic rings of the novolak are substituted in the ortho- and/or para-position to a phenolic hydroxyl group or to the diazoquinonesulfonyloxy group by a radical of formula $-CH(R^1)R^2$, in which

| | |
|---|---|
| $R^1$ | is hydrogen, alkyl, aryl or a carboxylic acid group, and |
| $R^2$ | is a sulfonic acid group $-SO_3H$, a radical $-A-R^3-X$ or a morpholino group, |
| $R^3$ | is a divalent aliphatic, aromatic or araliphatic group which is unsubstituted or substituted by a carboxylic, sulfonic or phosphonic acid group, |
| A | is a sulfur atom or a radical of formula $-N(R^4)-$, $R^4$ is hydrogen or alkyl which is unsubstituted or substituted by a carboxylic acid group, by a hydroxyl group or by an etherified hydroxyl group, and |
| X | is a carboxylic or sulfonic acid group, or, where A is $-N(R^4)-$, X is furthermore a phosphonic acid group, an amino group of formula $-N(R^5)(R^6)$, a hydrogen atom or a hydroxyl group, and |
| $R^5$ and $R^6$ | are independently of one another a hydrogen atom or an alkyl, aryl, aralkyl or alkenyl group, each of which is unsubstituted or substituted by a hydroxyl group. |

2. A resin according to claim 1, in which the diazoquinonesulfonyloxy group is a diazobenzo- or diazonaphthoquinonesulfonyloxy group.

3. An electrodepositable, photosensitive, phenolic novolak resin according to claim 1, of formula I

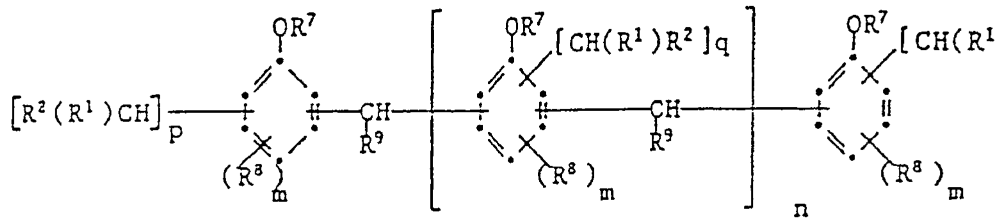

(I),

in which

$R^1$ and $R^2$ are as defined in claim 1, $R^7$ is hydrogen or alkyl which may be substituted by a hydroxyl or alkoxy group, or $R^7$ is a group of formula $SO_2R^{10}$, $-SO_2R^{11}$, or $-COR^{12}$, at least 4 % of the radicals $R^7$ being a group $-SO_2R^{10}$,

$R^8$ is a halogen atom, a hydroxyl or alkoxy group or a free or esterified carboxylic or sulfonic acid group or is an alkyl, alkenyl or aryl group which is unsubstituted or substituted by a hydroxyl group or a carboxylic acid group or is a radical of formula $-N(R^{13})R^{14}$, $-COR^{12}$, $-OCOR^{12}$, $-OSO_2R^{10}$ or $-OSO_2R^{12}$; or in which one group $R^8$ on each aromatic ring may be a group of formula II

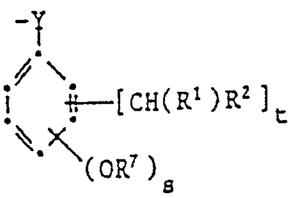

(II)

which may be linked to adjacent aromatic rings via groups of formula $-CH(R^9)-$, in which $R^9$ is hydrogen or alkyl, aryl, or a carboxylic acid group,

$R^{10}$ is a diazo-1,2-benzoquinone group or diazo-1,2-naphthoquinone group of formula III or IV

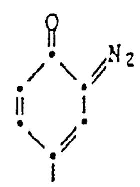

(III)

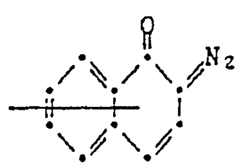

(IV),

the free valency bond of the naphthoquinone group being in the 4- or 5-position, $R^{11}$ and $R^{12}$ are independently of one another a monovalent aliphatic, cycloaliphatic, aromatic or araliphatic radical, $R^{13}$ is hydrogen, alkyl or a radical of formula $-COR^{12}$, $-SO_2R^{10}$ or $-SO_2R^{11}$, $R^{14}$ is hydrogen or alkyl,

Y is an oxygen or sulfur atom, a carbonyl or sulfonyl group, or a $C_1$-$C_8$alkylene group which is unsubstituted or substituted by a halogen atom, a hydroxyl group, an etherified hydroxyl group, a carboxyl group, an esterified carboxyl group or a $C_6$-$C_{12}$aryl group, where the said aryl group may likewise be substituted by a halogen atom, a hydroxyl group, an etherified hydroxyl group, a carboxylic acid group or an esterified carboxylic acid group,

m is 0 or 1, 2 or 3,

n is 0 or an integer from 1 to 20,

p, r and t are independently of one another 0, 1 or 2,

q is 0 or 1,
s is 1 or 2, and
the sum of p+nq+r+t is such that at least 4 % of the relevant aromatic rings are substituted by a group of formula $-CH(R^1)R^2$ in the ortho-and/or para-position to the group $-OR^7$,
the sum of m+p or m+r is not more than 4, and
the sum of m+q is not more than 3.

**4.** A resin according to claim 3, in which 10-50 % of the radicals $R^7$ are a group of formula $-SO_2R^{10}$, and in which 7-75 % of the aromatic rings are substituted by a group of formula $-CH(R^1)R^2$.

**5.** A resin according to any one of claims 1-4, in which alkyl, alkoxy and alkenyl radicals $R^1$, $R^4$, $R^5$, $R^6$, $R^7$, $R^5$, $R^{13}$ and $R^{14}$ have up to 20 carbon atoms, aryl and aralkyl radicals $R^1$, $R^5$, $R^6$, $R^8$ and $R^9$ have up to 20 carbon atoms, divalent groups $R^3$ have up to 15 carbon atoms when aliphatic, and up to 20 carbon atoms when aromatic or araliphatic, and monovalent radicals $R^{11}$ and $R^{12}$ have up to 20 carbon atoms when aliphatic, aromatic or araliphatic, and up to 15 carbon atoms when cycloaliphatic.

**6.** A resin according to any one of claims 1-5, in which $R^1$ is hydrogen, methyl, ethyl or phenyl or a carboxylic acid group.

**7.** A resin according to any one of claims 1-6, in which $R^2$ is a group of formula $-A-R^3-X$ in which $R^3$ is $C_1$-$C_6$alkylene which is unsubstituted or substituted by a carboxylic acid group, or is a phenylene group, A is a sulfur atom or a radical of formula $-N(R^4)-$, $R^4$ is hydrogen or $C_1$-$C_6$alkyl which may be substituted by a hydroxyl group, or is a carboxylic acid group, X is a carboxylic or sulfonic acid group when A is a sulfur atom or X is a hydrogen atom, a hydroxyl group, a carboxylic or sulfonic acid group, or an amino group of formula $-N(R^5)R^6$ when A is a group $-NR^4-$, $R^5$ and $R^6$ independently of one another representing hydrogen or $C_1$-$C_6$alkyl, or $R_2$ is a morpholino group.

**8.** A resin according to any one of claims 3-7, in which m is 0, so that $R^8$ is absent, or in which m is 1 and the various groups $R^8$ are identical or different $C_1$-$C_8$alkyl groups, or in which m is 0 for some of the aromatic rings of formula I and m is 1 for the remainder of these rings, the various radicals $R^8$ being identical or different $C_1$-$C_8$alkyl groups.

**9.** A resin according to any one of claims 1-8 which is a salt which is soluble or dispersible in an aqueous medium.

**10.** A process for the preparation of an electrodepositable, photosensitive resin according to claim 1 by reacting a phenolic novolak (A), prepared from a phenol (B) and an aldehyde (C), with a diazoquinonesulfonic acid (D) or a reactive derivative thereof, at least one of the components, i.e. the novolak (A), the phenol (B) and/or the reaction product of the novolak (A) and the diazoquinone (D) being further reacted with an aldehyde (E) and a component (F) selected from the group consisting of a primary or secondary amine, an acid having a primary or secondary amino group or a mercapto group and a carboxylic, sulfonic or phosphonic acid group, sulfurous acid, or a water-soluble salt of one of the said acids.

**11.** A process according to claim 10, comprising the reaction of the phenolic novolak resin (A) with the diazoquinonesulfonic acid (D) or one of its reactive derivatives, followed by the reaction of the product with the aldehyde (E) and the reactant (F), or comprising the reaction of the phenolic novolak resin (A) with the aldehyde (E) and the reactant (F), followed by the reaction of the resulting product with a diazoquinonesulfonic acid (D) or one of its reactive derivatives.

**12.** A process according to claim 10 or 11, in which the phenol (B) has the general formula V

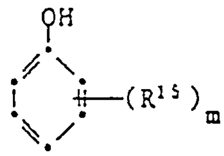

(V),

the aldehyde (C) has the formula $R^9$-CHO, the diazoquinonesulfonic acid (D) or its reactive derivative has the formula $R^{10}-SO_2-Z$, the aldehyde (E) has the formula $R^1$-CHO, and the reactant (F) has the formula $M_2SO_3$ or H-A-$R^3$-X, where R', $R^3$, A and X are as defined in claim 1, or ... is morpholine, $R^9$, $R^{10}$ and m are as defined in claim 3, $R^{15}$ is as defined for $R^8$ in claim 3, with the proviso that $R^{15}$ is, instead of the group of formula II, a group of formula VI

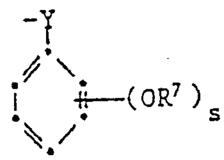

(VI),

in which Y, $R^7$ and s are as defined in claim 3, M is hydrogen or a monovalent metal atom, and Z is a hydroxyl or alkoxy group or a halogen atom.

**13.** A process according to any one of claims 10-12, in which the phenol (B) is phenol, o-, m- or p-cresol, o-, m- or p-tert-butylphenol, o-, m-or p-octylphenol, or a mixture of two or more of these compounds.

**14.** A process according to any one of claims 10-13, in which the aldehydes (C) and (E) are formaldehyde.

**15.** A process according to any one of claims 10-14, in which (D) is diazo-1,2-naphthoquinone-4- or -5-sulfonyl chloride or 2-diazo-1,2-benzoquinone-4-sulfonyl chloride.

**16.** A process according to any one of claims 10-15, in which the reactant (F) is an alkali metal sulfite, a primary or secondary alkylamine in which one or more of the alkyl groups may be substituted by alkoxy radicals, an alkylenediamine, morpholine, a hydroxylamine, an aminocarboxylic acid in which an amino group and a carboxyl group are attached to an aliphatic, aromatic or araliphatic radical, or a mercaptocarboxylic acid in which a mercapto group and a carboxyl group are attached to an aliphatic, aromatict or araliphatic radical.

**17.** A process according to any one of claims 10-16, in which the amount of (D) is from 0.1 to 0.75 mole per equivalent of phenolic hydroxyl group in the novolak resin (A), the amount of reactant (F) is from 0.04 to 2.0 moles per equivalent of phenolic hydroxyl group in the novolak resin (A) or in the reaction product of (A) and (D), and the amount of aldehyde (E) is from 1.1 to 4.0 moles per equivalent of (F).

**18.** A process according to any one of claims 10-17, in which the reaction between the aldehyde (E), the reactant (F) and the novolak resin (A) or the reaction product of (A) and the diazoquinone (D) is effected in an inert solvent at a temperature of 40 to 180 °C in the presence of sufficient base to neutralize, at least partially, the free acid.

**Revendications**

**1.** Novolaque phénolique photosensible applicable par un dépôt galvanique, dans laquelle :

I) au moins certains des hydroxyles phénoliques sont remplacés par des groupes quinone-diazidosulfonyloxy, et

II) au moins certains des cycles aromatiques de la novolaque portent un radical -CH($R^1$)$R^2$ à la position ortho et/ou para par rapport à un hydroxyle phénolique ou au groupe quinone-diazidosulfonyloxy, radical dans lequel

$R^1$ représente l'hydrogène ou bien un alkyle, un aryle ou un groupe carboxylique, et

$R^2$ un groupe d'acide sulfonique $-SO_3H$, un groupe $-A-R^3-X$ ou un groupe morpholino,

$R^3$ étant un groupe bivalent aliphatique, aromatique ou araliphatique, éventuellement substitué par un groupe d'acide carboxylique, sulfonique ou phosphorique,

A un atome de soufre ou un radical $-N(R^4)-$,

$R^4$ désignant l'hydrogène ou un alkyle éventuellement substitué par un groupe carboxylique ou par un groupe hydroxylique le cas échéant éthérifié, et

X désigne un groupe carboxylique ou sulfonique ou encore, si A est le radical $-N(R^4)-$, un groupe d'acide phosphonique, un groupe amino $-N(R^5)R^6$, un atome d'hydrogène ou un hydroryle,

$R^5$ et $R^6$ étant chacun, indépendamment l'un de l'autre, un atome d'hydrogène ou un groupe alkyle, aryle, aralkyle ou alcényle éventuellement substitués par un hydroxyle.

**2.** Résine selon la revendication 1 dans laquelle le groupe quinone-diazidosulfonyloxy est un groupe benzo- ou naphto-quinone-diazidosulfonyloxy.

**3.** Résine de novolaque phénolique selon la revendication 1, de formule I ci-dessous

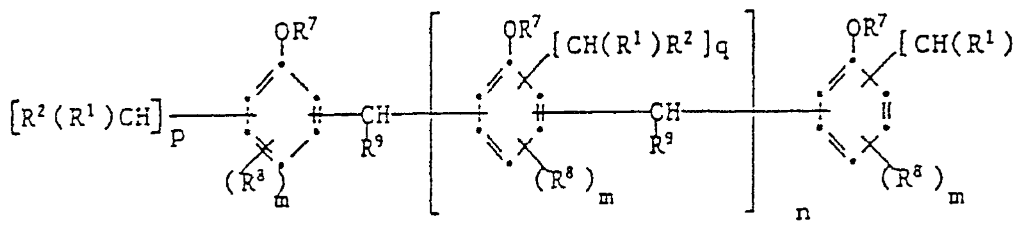

(I),

dans laquelle $R^1$ et $R^2$ ont les significations qui ont été indiquées à la revendication 1,
$R^7$ désigne l'hydrogène ou un alkyle pouvant être substitué par un hydroxyle ou un alcoxy, ou bien un groupe $-SO_2R^{10}$, $-SO_2R^{11}$ ou $-COR^{12}$, au moins 4% des radicaux $R^7$ étant un groupe $-SO_2R^{10}$,
$R^8$ désigne un atome d'halogène, un hydroxyle ou un alcoxy ou bien un groupe carboxylique ou sulfonique éventuellement estérifié ou un alkyle, un alcényle ou un aryle éventuellement substitué par un hydroxyle ou un groupe carboxylique, ou encore $R^8$ peut être un radical $-N(R^{13})R^{14}$, $-COR^{12}$, $-OCOR^{12}$, $-OSO_2R^{10}$ ou $-OSO_2R^{12}$, ou bien un groupe $R^8$ pouvant être par radical aromatique un groupe de formule II

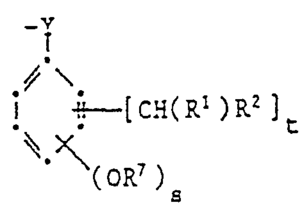

(II)

éventuellement relié aux cycles aromatiques voisins par des groupes $-CH(R^9)-$,
$R^9$ désignant l'hydrogène ou bien un alkyle, un aryle ou un groupe carboxylique,
$R^{10}$ un groupe 1,2-benzoquinonediazide ou 1,2-naphtoquinonediazide de formule III ou IV

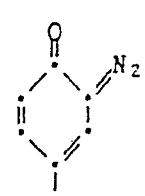

(III)

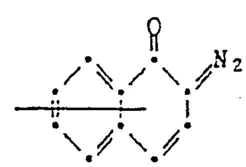

(IV),

la valence libre du groupe de naphtoquinone étant à la position 4 ou 5,
$R^{11}$ et $R^{12}$ désignant chacun, indépendamment l'un de l'autre, un radical monovalent aliphatique, cycloaliphatique, aromatique ou araliphatique,
$R^{13}$ l'hdyrogène, un alkyle ou un radical $-COR^{12}$, $-SO_2R^{10}$ ou $-SO_2R^{11}$,
$R^{14}$ l'hydrogène ou un alkyle,

Y un atome d'oxygène ou de soufre, un groupe carbonyle ou sulfonyle ou un alkylène en $C_1$-$C_8$ avec le cas échéant comme susbtituant un atome d'halogène, un hydroxyle éventuellement éthérifié, un groupe carboxylique éventuellement esterifié ou un aryle en $C_6$-$C_{12}$, aryle qui peut lui-même avoir éventuellement comme substituant un atome d'halogène, un hydroxyle éventuellement éthérifié ou un groupe carboxylique éventuellement estérifié,
m est le nombre 0, 1, 2 ou 3,
n un entier de 0 à 20,
p, r et t sont chacun le nombre 0, 1 ou 2, indépendamment les uns des autres,
g = 0 ou 1,
s = 1 ou 2,

et la somme (p+nq+r+t) est déterminée de manière qu'au moins 4% des cycles aromatiques concernés portent un radical $-CH(R^1)R^2$ à la position ortho et/ou para par rapport au groupe $-OR^7$, la somme m+p ou m+r ne dépassant pas 4 et la somme m+q ne dépassant pas 3.

**4.** Résine selon la revendication 3 dans laquelle de 10 à 50% des radicaux $R^7$ sont un groupe $-SO_2R^{10}$ et de 7 à 75% des cycles aromatiques portent comme substituant un groupe $-CH(R^1)R^2$.

**5.** Résine selon l'une des revendications 1 à 4 dans laquelle les radicaux $R^1$, $R^4$, $R^5$, $R^6$, $R^7$, $R^8$, $R^{13}$ et $R^{14}$, en tant qu'alkyles, alcoxys ou alcényles, peuvent avoir jusqu'à 20 atomes de carbone, les radicaux $R^1$, $R^5$, $R^6$, $R^8$ et $R^9$ en tant qu'aryles ou aralkyles, peuvent avoir également jusqu'à 20 atomes de carbone, les radicaux bivalents $R^3$ peuvent avoir jusqu'à 15 atomes de carbone si ce sont des radicaux aliphatiques et jusqu'à 20 si ce sont des radicaux aromatiques ou araliphatiques, et les radicaux monovalents $R^{11}$ et $R^{12}$ peuvent avoir jusqu'à 20 atomes de carbone s'il s'agit de radicaux aliphatiques, aromatiques ou araliphatiques, et jusqu'à 15 seulement s'il s'agit de radicaux cycloaliphatiques.

**6.** Résine selon l'une des revendications 1 à 5 dans laquelle $R^1$ est l'hydrogène ou bien le groupe méthyle, éthyle ou phényle ou encore un groupe d'acide carboxylique.

**7.** Résine selon l'une des revendications 1 à 6 dans laquelle $R^2$ est un groupe $-A-R^3-X$, $R^3$ désignant un alkylène en $C_1$-$C_6$ qui porte éventuellement un groupe carboxylique, ou bien un phénylène, A un atome de soufre ou un radical $-N(R^4)-$, $R^4$ étant l'hydrogène ou un alkyle en $C_1$-$C_6$ pouvant avoir un hydroxyle, ou encore un groupe carboxylique, et X un groupe d'acide carboxylique ou sulfonique si A est un atome de soufre, ou bien si A est un groupe $-NR^4-$, X désignant un atome d'hydrogène, un hydroxyle ou bien un groupe carboxylique ou sulfonique ou un groupe amino $-N(R^5)R^6$, $R^5$ et $R^6$ étant chacun, indépendamment l'un de l'autre, l'hydrogène ou un alkyle en $C_1$-$C_6$, ou encore $R^2$ peut être un groupe morpholino.

**8.** Résine selon l'une des revendications 3 à 7 dans laquelle m = 0, c'est-à-dire qu'il n'y a pas de radical $R^8$, ou bien m = 1 et dans ce cas les divers groupes $R^8$, qui peuvent être identiques ou différents, sont des alkyles en $C_1$-$C_8$, ou dans laquelle pour certains des cycles aromatiques de la formule I m = 0 et pour les autres de ces cycles m = 1, les divers groupes $R^8$, qui peuvent être identiques ou différents, étant des alkyles en $C_1$-$C_8$.

**9.** Résine selon l'une des revendications 1 à 8, caractérisée en ce qu'elle est à l'état d'un sel soluble ou pouvant être dipersé dans un milieu aqueux.

**10.** Procédé de préparation de résines photosensibles applicables par un dépôt galvanique, selon la revendication 1, par réaction d'une novolaque phénolique (A), obtenue à partir d'un phénol (B) et d'un aldéhyde (C), avec un acide quinone-diazidosulfonique (D) ou un dérivé réactif de cet acide, en faisant également réagir l'un au moins de ces composants, c'est-à-dire la novolaque (A), le phénol (B) et/ou le produit de réaction de la novolaque (A) avec le quinone-diazide (D), avec un aldéhyde (E) et un

composant (F) pris parmi une amine primaire ou secondaire, un acide portant un groupe amino primaire ou secondaire ou un groupe mercapto et un groupe d'acide carboxylique, sulfonique ou phosphonique, l'acide sulfureux et un sel hydrosoluble de l'un des acides concernés.

**11.** Procédé selon la revendication 10, qui comprend la réaction de la novolaque phénolique (A) avec l'acide quinone-diazidosulfonique (D) ou un dérivé réactif de cet acide, suivie de la réaction du produit formé avec l'aldéhyde(E) et avec le réactif (F) ; ou bien qui comprend la réaction de la novolaque phénolique (A) avec l'aldéhyde (E) et le réactif (F), suivie d'une réaction du produit ainsi formé avec l'acide quinonediazidosulfonique (D) ou un dérivé réactif de celui-ci.

**12.** Procédé selon la revendication 10 ou 11 dans lequel le phénol (B) a la formule générale V ci-dessous

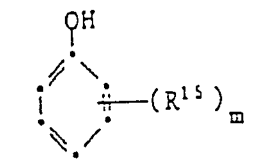

(V),

l'aldéhyde (C) la formule $R^9$-CHO, l'acide quinonediazidosulfonique (D) ou son dérivé réactif a la formule $R^{10}-SO_2-Z$, l'aldéhyde (E) la formule $R^1$-CHO et le réactif (F) la formule $M_2SO_3$ ou $H-A-R^3-X$, $R^1$, $R^3$, A et X ayant les significations indiquées à la revendication 1, ou bien il s'agit du groupe morpholino, $R^9$, $R^{10}$ et m ayant les significations données à la revendication 3, $R^{15}$ la signification donnée pour $R^8$ à la revendication 3 à condition que ce soit, au lieu du groupe de formule II, un groupe de formule VI

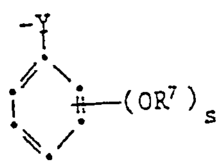

(VI),

dans laquelle Y, $R^7$ et s ont les significations données à la revendication 3, M étant l'hydrogène ou un atome de métal monovalent et Z un hydroxyle, un groupe alcoxy ou un atome d'halogène.

**13.** Procédé selon l'une des revendications 10 à 12 dans lequel le phénol (B) est le phénol lui-même, le o-, m- ou p-crésol, le o-, m-, ou p-tert.butylphénol, le o-, m-, ou p-octylphénol ou encore un mélange de deux de ces phénols ou plus.

**14.** Procédé selon l'une des revendications 10 à 13 dans lequel les aldéhydes (C) et (E) sont chacun le formaldéhyde.

**15.** Procédé selon l'une des revendications 10 à 14 dans lequel (D) est le chlorure de 1,2-naphtoquinonediazido-4- ou -5-sulfonyle, ou le chlorure de 1,2-benzoquinone-2-diazido-4-sulfonyle.

**16.** Procédé selon l'une des revendications 10 à 15, dans lequel le réactif (F) est un sulfite de métal alcalin, une alkylamine primaire ou secondaire dont un ou plusieurs des alkyles peuvent porter des groupes alcoxy, une alkylène-diamine, la morpholine ou une hydroxylamine ou encore un acide aminocarboxylique dont un groupe amino et un groupe carboxylique sont liés à un radical aliphatique, aromatique ou araliphatique, ou un acide mercaptocarboxylique dont un groupe mercapto et un groupe carboxylique sont également liés à un radical aliphatique, aromatique ou araliphatique.

**17.** Procédé selon l'une des revendications 10 à 16 dans lequel la proportion de (D) est de 0,1 à 0,75 mol par équivalent de l'hydroxyle phénolique de la résine de novolaque (A), la proportion du réactif (F) est

de 0,04 à 2,0 mol par équivalent de l'hydroxyle phénolique de la novolaque (A) ou du produit de réaction de (A) avec (D) et la proportion de l'aldéhyde (E) est de 1,1 à 4,0 mol par équivalent du réactif (F).

**18.** Procédé selon l'une des revendications 10 à 17 dans lequel la réaction entre l'aldéhyde (E), le réactif (F) et la résine de novolaque (A) ou le produit de réaction de (A) avec le quinodiazide (D) est effectuée dans un solvant inerte à une température de 40 à 180 °C, en présence d'une base en quantité suffisante pour neutraliser au moins une partie de l'acide libre.